(19) Europäisches Patentamt
European Patent Office
Office européen des brevets

(11) Veröffentlichungsnummer: **0 198 798 B1**

(12) **EUROPÄISCHE PATENTSCHRIFT**

(45) Veröffentlichungstag der Patentschrift: **29.05.91**

(51) Int. Cl.$^5$: **C08G 69/26**, C08G 69/44, C08G 63/18, C08G 63/68

(21) Anmeldenummer: **86810162.7**

(22) Anmeldetag: **07.04.86**

(54) **Strahlungsempfindliche Polykondensate, Verfahren zu deren Herstellung, beschichtetes Material und dessen Verwendung.**

(30) Priorität: **11.04.85 CH 1552/85**

(43) Veröffentlichungstag der Anmeldung:
**22.10.86 Patentblatt 86/43**

(45) Bekanntmachung des Hinweises auf die Patenterteilung:
**29.05.91 Patentblatt 91/22**

(84) Benannte Vertragsstaaten:
**BE CH DE FR GB IT LI NL SE**

(56) Entgegenhaltungen:
**EP-A- 0 006 686**
**DE-A- 2 243 997**
**JP-A- 7 928 396**
**US-A- 4 250 182**
**EP-A- 0 138 768**
**DE-A- 2 344 814**
**US-A- 3 859 307**

**CHEMICAL ABSTRACTS, Band 91, Nr. 4, 23. Juli 1979, Zusammenfassung Nr. 21422h, Columbus, Ohio, US; && JP - A - 79 28396**

(73) Patentinhaber: **CIBA-GEIGY AG**
**Klybeckstrasse 141**
**CH-4002 Basel(CH)**

(72) Erfinder: **Pfeifer, Josef, Dr.**
**Brunnmattstrasse 32**
**CH-4106 Therwil(CH)**
Erfinder: **Duthaler, Rudolf, Dr.**
**Streulistrasse 73**
**CH-8032 Zürich(CH)**

EP 0 198 798 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft strahlungsempfindliche lineare gesättigte Homo- und Copolykondensate aus der Gruppe der Polyester, Polyamide und Polyesteramide, ein mit diesen Polykondensaten beschichtetes Material und dessen Verwendung zur Herstellung von Schutzüberzügen oder photographischen Abbildungen.

Aus der US-PS 3 926 639 ist es bekannt, dass Polymere, die Reste von Benzophenoncarbonsäuren enthalten, autophotopolymerisierbar sind oder als Photoinitiatoren für photopolymerisierbare Verbindungen geeignet sind. Es werden auch allgemein Polyester und Polyamide erwähnt. Als photopolymerisierbare Gruppen enthalten diese Polyester und Polyamide Reste von ethylenisch ungesättigten Carbonsäuren oder Alkoholen. Ferner sind in den Beispielen gesättigte und vernetzte Polyester beschrieben, die aus tri- und tetrafunktionellen Carbonsäuren und Alkoholen im Gemisch mit Dicarbonsäuren und Diolen erhalten werden. Bei diesen Polyestern handelt es sich um weiche und klebrige Materialien. Solche Materialien sind schwierig zu handhaben und ihre thermomechanischen Eigenschaften genügen nicht Anforderungen in verschiedenen Anwendungsbereichen, die an solche Materialien gestellt werden.

Aus der JP-A-54-28,396 sind aromatische Copolyamide auf Basis von Terephthalsäure, Fluorenondicarbonsäure und p-Phenylendiamin bekannt. Nach der Beschreibung eignen sich die Polymeren zur Herstellung von Fasern oder Filmen mit guter Hitzebeständigkeit und guten mechanischen Eigenschaften.

Gegenstand der vorliegenden Erfindung ist ein Verfahren zur Herstellung von vernetzten Polymeren, dadurch gekennzeichnet, dass man strahlungsempfindliche lineare gesättigte Homo- und Copolykondensate mit energiereicher Strahlung bestrahlt, wobei besagte Polykondensate ausgewählt sind aus der Gruppe der Polyester, Polyesteramide und Polyamide mit mindestens einem wiederkehrenden Strukturelement der Formel I

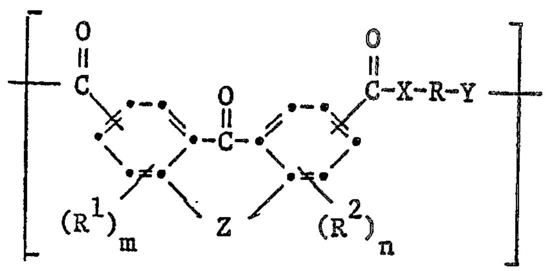

(I)

und im Fall von Copolykondensaten zusätzlich wiederkehrenden Strukturelementen der Formel II

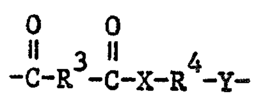

(II),

worin m und n unabhängig voneinander für eine Zahl von 0 bis 3 stehen, X und Y unabhängig voneinander für -S-, -O- oder $-NR^5-$ stehen, Z eine direkte Bindung, $-CH_2-$, -O-, -S-,-SO-, $-SO_2-$, -CO-, $-NR^6-$ oder $-CR^6R^7-$ bedeutet, wobei $R^6$ ein Wasserstoffatom, $C_1$-$C_{10}$-Alkyl, Phenyl, Naphthyl oder Phenyl($C_aH_{2a}$) mit a = 1 bis 4 ist und $R^7$ die Bedeutung von $R^6$ mit Ausnahme der Bedeutung eines Wasserstoffatomes hat, $R^1$ und $R^2$ unabhängig voneinander für $C_1$-$C_{10}$-Alkyl, Halogen, -CN, $-NO_2$, $C_1$-$C_{12}$-Alkoxy, Phenoxy, Naphthoxy oder Phenyl-($C_aH_{2a}$) mit a = 1-4 stehen,
R einen unsubstituierten oder substituierten zweiwertigen aliphatischen, cycloaliphatischen, araliphatischen oder aromatischen Rest bedeutet, und falls X und Y die Gruppe $-NR^5-$ sind, R und eines der $R^5$ zusammen Alkylen mit 5 bis 7 C-Atomen, an das die zweite $-NR^5$-Gruppe gebunden ist, oder R Methylen, Ethylen oder Propylen und die beiden $R^5$ der $NR^5$-Gruppen zusammen Ethylen oder Propylen oder falls X oder Y -S- oder -O- und das andere $-NR^5-$ sind, R und $R^5$ zusammen Alkylen mit 5-7 C-Atomen bedeuten,
$R^4$ unabhängig die gleiche Bedeutung wie R hat,
$R^3$ ein zweiwertiger gesättigter aliphatischer oder aromatischer Rest ist und
$R^5$ ein Wasserstoffatom, Alkyl, Cycloalkyl, Aryl, Aralkyl oder Alkaralkyl bedeutet,
wobei die Copolykondensate die Strukturelemente der Formel I zu mindestens 10 Mol.-% enthalten,

bezogen auf das Copolykondensat.

Die Homo- und Copolyester, -esteramide und -amide enthaltend mindestens 10 Mol% des oben definierten Strukturelementes der Formel I, worin m, n, X, Y, R, $R^1$, $R^2$, $R^3$, $R^4$, $R^5$, $R^6$ und $R^7$ die oben definierte Bedeutung besitzen und Z ausgewählt ist aus der Gruppe bestehend aus $-CH_2-$, -O-, -S-, -SO-, $-SO_2-$, -CO-, $-NR^6-$ und $-CR^6R^7-$ sind ebenfalls Gegenstand der vorliegenden Erfindung.

In den Formeln I und II haben X und Y bevorzugt die gleiche Bedeutung und vorteilhaft stehen X und Y in den Formeln I und II für eine $-NR^5$-Gruppe oder -O-.

Der Anteil der Strukturelemente der Formel I beträgt in den Polykondensaten bevorzugt mindestens 50 Mol.-%, besonders mindestens 70 Mol.-% und insbesondere mindestens 90 Mol.-%. Der Anteil richtet sich im wesentlichen nach der gewünschten Strahlungsempfindlichkeit der Polykondensate.

In der Formel I stehen m und n bevorzugt für 1 und insbesondere für 0. $R^1$ und $R^2$ sind unabhängig voneinander bevorzugt Alkyl oder Alkoxy mit 1 bis 4 C-Atomen, besonders Methyl, Ethyl und Methoxy, oder Halogen, besonders Br oder Cl.

$R^5$ enthält als lineares oder verzweigtes Alkyl bevorzugt 1 bis 6 C-Atome, als Cycloalkyl 5 bis 7 Ringkohlenstoffatome und kann Cyclopentyl, Cyclohexyl oder Methylcyclohexyl sein. $R^5$ als Arylreste sind besonders Phenylreste, z.B. Phenyl, Methylphenyl oder Benzyl. Besonders bevorzugt ist $R^5$ ein Wasserstoffatom.

Die Carbonylgruppen in dem Strukturelement der Formel I sind bevorzugt in Metastellung und besonders in Parastellung zur Carbonylgruppe im Ring gebunden.

R und $R^4$ in den Formeln I und II in der Bedeutung als zweiwertiger aliphatischer Rest enthalten bevorzugt 2 bis 30 C-Atome. Besonders enthalten die Reste R und $R^4$ 6 bis 30 und insbesondere 6 bis 20 C-Atome, wenn X und Y die $NR^5$-Gruppe bedeuten. Wenn X und Y in den Formeln I und II für -S- oder -O- stehen, enthält der aliphatische Rest bevorzugt 2 bis 20 und besonders 20 bis 12 C-Atome. In einer bevorzugten Untergruppe sind R und $R^4$ lineares oder verzweigtes Alkylen, das durch Sauerstoffatome, NH, $NR^a$, $^+NR^a_2\ G^-$, Cyclopentylen, Cyclohexylen, Naphthylen, Phenylen, oder Hydantoinreste unterbrochen sein kann. $R^a$ kann z.B. Alkyl mit 1 bis 12 C-Atomen oder Cycloalkyl mit 5 oder 6 Ring-C-Atomen, Phenyl oder Benzyl sein. $G^-$ bedeutet ein Anion einer Protonensäure, z.B. Halogenid, Sulfat, Phosphat. In einer weiteren bevorzugten Ausführungsform sind R und $R^4$ lineares oder verzweigtes Alkylen, $-(CH_2)_x-R^8-(CH_2)_y-$, worin $R^8$ Phenylen, Naphthylen, Cyclopentylen oder Cyclohexylen und x und y unabhängig voneinander die Zahl 1, 2 oder 3 sind,

$$-R^9-(OR^{10})-O-R^9-,$$

worin $R^9$ Ethylen, 1,2-Propylen, 1,3-Propylen oder 2-Methyl-1,3-Propylen und $R^{10}$ Ethylen, 1,2-Propylen, 1,2-Butylen, 1,3-Propylen oder 1,4-Butylen und p eine Zahl von 1 bis 100 sind, oder

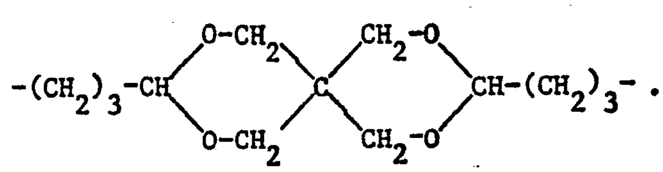

Beispiele für aliphatische Reste sind: Ethylen, 1,2- oder 1,3-Propylen, 2,2-Dimethyl-1,3-propylen, 1,2-, 1,3- oder 1,4-Butylen, 1,3- oder 1,5-Pentylen, Hexylene, Heptylene, Octylene, Decylene, Dodecylene, Tetradecylene, Hexadecylene, Octadecylene, Eicosylene, 2,4,4-Trimethylhexylen, 1,10-Dialkyldecylen, wobei das Alkyl bevorzugt 1 bis 6 C-Atome aufweist, substituierte 1,11-Undecylene, wie sie z.B. in der EP-B-O 011 559 beschrieben sind, zweiwertige Reste von Jeffaminen wie z.B.

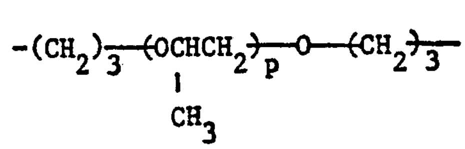

mit p = 1 bis 100 oder

$$-(CH_2)_3-(O(CH_2)_4)_p-O-(CH_2)_3-$$

mit p = 1-100, Dimethylencyclohexan, Xylylen und Diethylenbenzol. Besonders bevorzugt sind R und $R^4$ längerkettiges, verzweigtes Alkylen mit z.B. 8 bis 30 C-Atomen, wenn X und Y in den Formeln I und II für die $-NR^5$-Gruppen stehen.

Wenn X und Y in den Formeln I und II für -O- oder -S- stehen, sind R und $R^4$ bevorzugt lineares Alkyl mit 2 bis 12, besonders 2 bis 6 C-Atomen.

Bei den durch heterocyclische Reste unterbrochenen aliphatischen Resten kann es sich z.B. um solche handeln, die sich von N,N'-aminoalkylierten bzw. N,N'-hydroxyalkylierten Hydantoinen oder Benzimidazolen ableiten. Beispiele sind N,N'-(γ-Aminopropyl)-5,5-dimethylhydantoin oder -benzimidazolon und solche der Formel

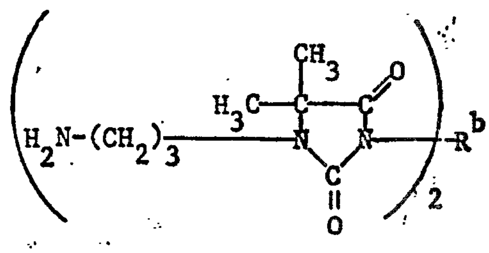
,

worin $R^b$ Alkylen mit 1 bis 12 bevorzugt 1 bis 4 C-Atomen oder

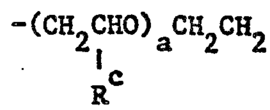

ist, worin $R^c$ ein Wasserstoffatom oder Methyl und a ganze Zahlen von 1-20 bedeuten.

Beispiel für entsprechende Diole sind N,N'-(β-hydroxyethyl)-5,5-dimethylhydantoin, N,N'-(β-hydroxyethyl)benzimidazolon und N,N'-(β-hydroxyethyl)-4,5,6,7-tetrabrombenzimidazolon.

Geeignete Substituenten für die aliphatischen Reste sind z.B. Halogene wie F oder Cl und Alkyl oder Alkoxy mit 1 bis 6 C-Atomen.

R und $R^4$ in den Formeln I und II in ihrer Bedeutung als zweiwertiger cycloaliphatischer Rest enthalten bevorzugt 5 bis 8 Ring-C-Atome und sind besonders unsubstituiertes oder mit Alkyl, das vorzugsweise 1 bis 4 C-Atome enthält, substituiertes ein- oder zweikerniges Cycloalkylen mit 5 bis 7 Ring-C-Atomen. In einer bevorzugten Ausführungsform sind R und $R^4$ als cycloaliphatische Reste solche der Formeln

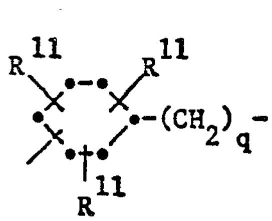
oder
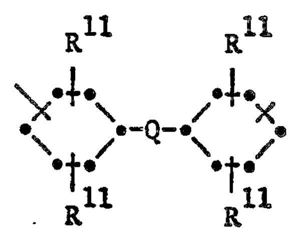
,

worin q 0 oder 1 ist, die $R^{11}$ unabhängig Wasserstoff oder Alkyl mit 1 bis 6 C-Atomen bedeuten und Q für eine direkte Bindung, O, S, $SO_2$, Alkylen mit 1 bis 3 C-Atomen oder Alkyliden mit 2 bis 6 C-Atomen steht. $R^{11}$ ist bevorzugt Ethyl und Methyl, Q bevorzugt Methylen und das Alkyliden enthält bevorzugt 2 oder 3 C-Atome, wie Ethyliden und 1,1- oder 2,2-Propyliden.

Beispiele für R und $R^4$ als Cycloalkylen sind: 1,2- oder 1,3-Cyclopentylen, 1,2-, 1,3- oder 1,4-Cyclohexylen, Cycloheptylen, Cyclooctylen, Methylcyclopentylen, Methyl- oder Dimethylcyclohexylen, 3- oder 4-Methylcyclohex-1-yl, 5-Methyl-3-methylencyclohex-1-yl, 3,3'-oder 4,4'-Bis-cyclohexylen, 3,3'-Dimethyl-4,4'-biscyclohexylen, 4,4'-Biscyclohexylenether oder -sulfon- oder -methan oder -2,2-propan, sowie die zweiwertigen Reste von Bis-aminomethyl-tricyclodecan, Bisaminomethylnorbornan und Methandiamin. Besonders bevorzugt als zweiwertiger cycloaliphatischer Rest ist 1,4- oder 1,3- Cyclohexylen, Methylenbis(cyclohex-4-yl) oder Methylenbis(3-methyl-cyclohex-4-yl).

R und $R^4$ als araliphatische Reste enthalten bevorzugt 7 bis 30 C-Atome. Sofern die aromatische Gruppe des araliphatischen Restes an N-Atome im Rest der Formeln I und II gebunden ist, was bevorzugt ist, so sind diese aromatischen Gruppen bevorzugt so substituiert wie R und $R^4$ als aromatischer Rest, einschliesslich der Bevorzugungen. Der araliphatische Rest enthält bevorzugt 7 bis 26, besonders 8 bis 22 C-Atome. Der aromatische Rest im araliphatischen Rest ist bevorzugt ein Phenylrest. In ihrer Bedeutung als araliphatischer Rest sind R und $R^4$ besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

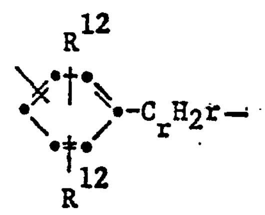

worin die $R^{12}$ unabhängig voneinander ein Wasserstoffatom oder besonders Alkyl mit 1-6 C-Atomen und r ganze Zahlen von 1-20 bedeuten. Die freie Bindung kann sich in o-Stellung, m-Stellung und besonders in p-Stellung zur $C_rH_{2r}$-Gruppe befinden und eine oder beide $R^{12}$ sind bevorzugt in o-Stellung zur freien Bindung gebunden. Für X und Y in der Bedeutung von -O- oder -S- ist der araliphatische Rest bevorzugt substituiert.

Beispiele für R und $R^4$ als zweiwertiger araliphatischer Rest sind: m- oder p-Benzylen, 3-Methyl-p-benzylen, 3-Ethyl-p-benzylen, 3,5-Dimethyl-p-benzylen, 3,5-Diethyl-p-benzylen, 3-Methyl-5-ethyl-p-benzylen, p-Phenylenpropylen, 3-Methyl-p-phenylen-propylen, p-Phenylenbutylen, 3-Ethyl-p-phenylenpentylen sowie insbesondere längerkettige Phenylenalkylenreste von Diaminen, die z.B. in der EP-A-O 069 062 beschrieben sind: 6-(p-Phenylen-6-methylhept-2-yl, 6-(3'-Methyl-p-phenylen)-6-methylhept-2-yl, 6-(3'-Ethyl-p-phenylen)-6-methylhept-2-yl, 6-(3',5'-Dimethyl-p-phenylen)-6-methylhept-2-yl, 11-(p-Phenylen)-2,11-dimethyl-dodec-1-yl, 13-(p-Phenylen)-2,12-dimethyltetradec-3-yl.

Unter den Homo- und Copolykondensaten sind besonders solche mit Strukturelementen der Formeln I und II bevorzugt, in der R und $R^4$ unsubstituierte und besonders substituierte aromatische Reste bedeuten und X und Y die $-NR^5$-Gruppe sind. Der Substituent am aromatischen Rest enthält bevorzugt 1 bis 20, besonders 1-12 und insbesondere 1-6 C-Atome. Insbesondere ist der Substituent lineares oder verzweigtes Alkyl, Alkoxy, oder Alkoxyalkyl mit 1 bis 6 C-Atomen, Benzyl, Trimethylen oder Tetramethylen. Als Alkoxyalkyl ist Alkoxymethyl bevorzugt und als Alkoxy Methoxy. Beispiele für den Substituenten sind: Methyl, Ethyl, Propyl, Isopropyl, n-Butyl, Isobutyl, Pentyl, Hexyl, Octyl, Dodecyl, Tetradecyl, Eicosyl, Methoxy, Ethoxy, Propoxy, Butoxy, Pentoxy, Hexoxy, Methoxymethyl, Methoxyethyl, Ethoxymethyl, Propoxymethyl, Butoxymethyl, Benzyl, Methylbenzyl und Phenylethyl. Bevorzugte Reste sind Methoxymethyl, Ethoxymethyl, Methyl, Ethyl, Trimethylen und Tetramethylen. Besonders bevorzugt ist Methyl und Ethyl. Bei dem aromatischen Rest kann es sich um einkernige oder mehrkernige, besonders zweikernige Reste handeln. Einkernige Reste können 1 bis 4, bevorzugt 2 bis 4 und besonders 4 Substituenten enthalten und zweikernige Reste können 1 bis 4, bevorzugt 2 Substituenten in jedem Kern enthalten. Es wurde gefunden, dass die Lichtempfindlichkeit von Homo- oder Copolykondensaten besonders hoch ist, wenn ein und besonders zwei Substituenten in Orthostellung zur X- bzw. Y-Gruppe gebunden sind und X und Y $-NR^5$- sind. Ferner weisen solche Polykondensate besonders gute thermomechanische Eigenschaften auf. Die Substitution in einer oder beiden Orthostellungen ist daher in diesem Fall bevorzugt. Der aromatische Rest ist bevorzugt in Meta- oder Para-stellung zur X- bzw. Y-Gruppe gebunden. Falle X und Y für -O- oder -S- stehen, sind unsubstituierte zweikernige aromatische Reste bevorzugt.

R kann als aromatischer Rest 6 bis 30, besonders 6 bis 20 C-Atome enthalten. Der aromatische Rest ist bevorzugt eine Kohlenwasserstoffrest, besonders ein ein- oder zweikerniger Phenylenrest, ein Naphthylenrest oder ein Pyridinrest, der durch Alkyl, Alkoxyalkyl, Alkoxy, Trimethylen oder Tetramethylen substituiert ist.

Eine bevorzugte Untergruppe sind solche aromatische Reste der Formeln

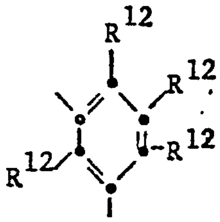 , 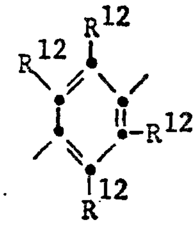 , 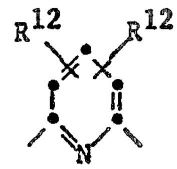 ,

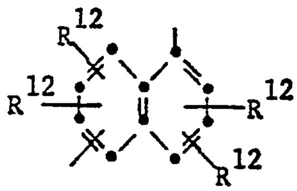 , 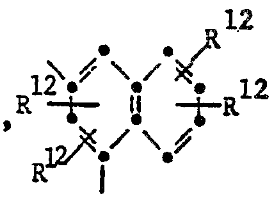 , 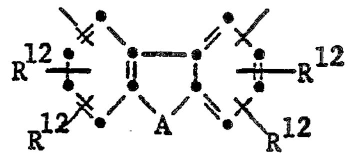 ,

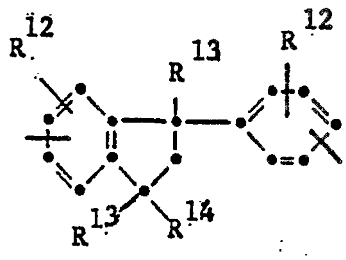 oder

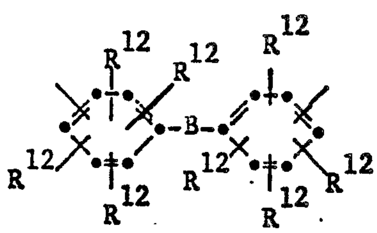 ,

worin alle $R^{12}$ ein Wasserstoffatom, $R^{12}$ im Falle der Monosubstitution Alkyl mit 1 bis 6 C-Atomen und die anderen $R^{12}$ Wasserstoffatome sind, und im Falle der Di, Tri oder Tetrasubstitution zwei $R^{12}$ Alkyl mit 1 bis 6 C-Atomen und die anderen $R^{12}$ ein Wasserstoffatom oder Alkyl mit 1 bis 6 C-Atomen sind oder im Falle der Di-, Tri oder Tetrasubstitution zwei vicinale $R^{12}$ im Phenylring für Trimethylen oder Tetramethylen und die anderen $R^{12}$ für ein Wasserstoffatom oder Alkyl mit 1 bis 6 C-Atomen stehen, A für O, S, NH, CO oder $CH_2$ steht, $R^{13}$ ein Wasserstoffatom oder Alkyl mit 1 bis 5 C-Atomen und $R^{14}$ Alkyl mit je 1 bis 5 C-Atomen darstellt, und B eine direkte Bindung, O, S, SO, $SO_2$, CO,

$$\overset{O}{\overset{\|}{C}}O,\ \overset{O}{\overset{\|}{C}}NR^{15},$$

$NR^{15}$, CONH, NH, $R^{15}SiR^{16}$, $R^{15}OSiOR^{16}$, Alkylen mit 1 bis 6 C-Atomen, Alkenylen oder Alkyliden mit 2 bis 6 C-Atomen, Phenylen oder Phenyldioxyl bedeutet, worin $R^{15}$ und $R^{16}$ unabhängig voneinander Alkyl mit 1 bis 6 C-Atomen oder Phenyl bedeuten. $R^{13}$ und $R^{14}$ sind bevorzugt Methyl, A steht bevorzugt für $-CH_2-$ oder -O- und B bevorzugt für eine direkte Bindung, -O-, $-CH_2-$ oder Alkyliden mit 2 bis 4 C-Atomen. $R^{15}$ und $R^{16}$ stehen besonders für Methyl, Ethyl und Phenyl. Das Alkylen enthält bevorzugt 2 bis 4 C-Atome und ist besonders Ethylen. Alkenylen ist besonders Ethenylen.

Eine bevorzugte Untergruppe sind Toluylenreste, Reste o,o'-substituierter Diaminodiphenylene, Diaminodiphenylmethane und Diaminodiphenylether.

Eine besonders bevorzugte Gruppe sind solche aromatischen Reste der Formeln

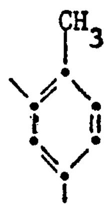, 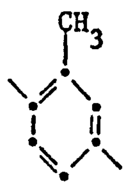, 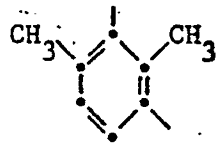, 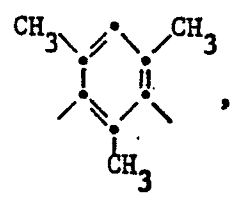, 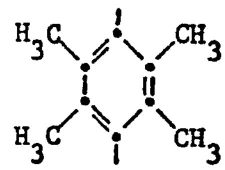,

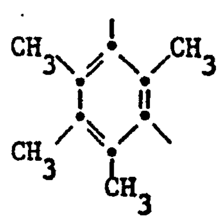 oder 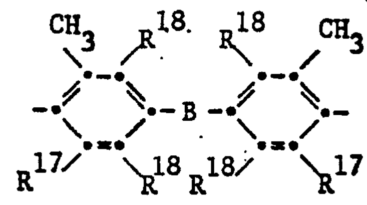

worin B eine direkte Bindung, O und besonders $CH_2$ bedeutet, $R^{17}$ ein Wasserstoffatom und besonders Methyl oder Ethyl darstellt und $R^{18}$ ein Wasserstoffatom, Methyl oder Ethyl ist.

Beispiele für unsubstituierte und substituierte aromatische Reste sind 1,3- oder 1,4-Phenylen, 2,4- oder 2,7-Naphthylen, 4,4'-Diphenylen, 4,4'-Diphenylenmethan, 4,4'-Diphenylenether, 4-Methyl-1,3-phenylen, 4-Ethyl-1,3-phenylen, 2-Methyl-1,3-phenylen, 4-Benzyl-1,3-phenylen, 4-Methoxymethyl-1,3-phenylen, Tetrahydro-1,3- oder -1,4-naphthylen, 3-Propyl-1,3- oder -1,4-phenylen, 3-Isopropyl-1,4-phenylen, 3,5-Dimethyl-1,4-phenylen, 2,4-Dimethyl-1,3-phenylen, 2,3-Dimethyl-1,4-phenylen , 5-Methyl-1,3-phenylen, 2,3,5,6-Tetramethyl-1,4- oder -1,3-phenylen, 3-Methyl-2,6-pyridylen, 3,5-Dimethyl-2,6-pyridylen, 3-Ethyl-2,6-pyridylen, 1-Methyl-2,7-naphthylen, 1,6-Dimethyl-2,7-naphthylen, 1-Methyl-2,4-naphthylen, 1,3-Dimethyl-2,4-naphthylen, die zweiwertigen Reste von 5-Amino-1-(3'-amino-4'-methylphenyl)-1,3,3-trimethylindan oder 6-Amino-5-methyl-1-(3'-amino-4'-methyl-1,3,3-trimethylindan, 4-Methoxymethyl-1,3-phenylen, 3-Methyl-p-diphenylen, 3-Ethyl-p-diphenylen, 3,3'-Dimethyl-p-diphenylen, 3,3'-Diethyl-p-diphenylen, 3-Methyl-3'-ethyl-p-diphenylen, 3,3'5,5'-Tetramethyl-diphenylen, 3,3'-Methyl-5,-'-ethyl-p-diphenylen, 4,4'-Dimethyl-m-diphenylen, 3,3'-Diisopropyl-diphenylen, Reste der Formeln

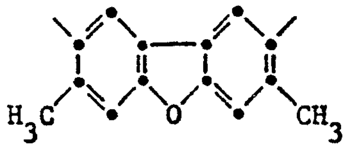 , 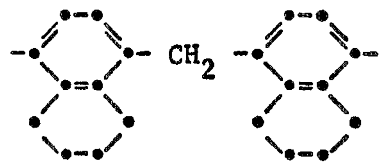 ,

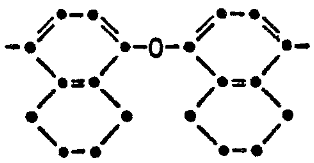 , 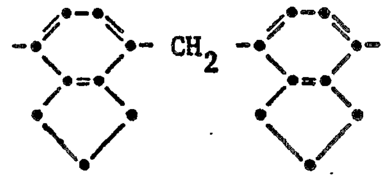 ,

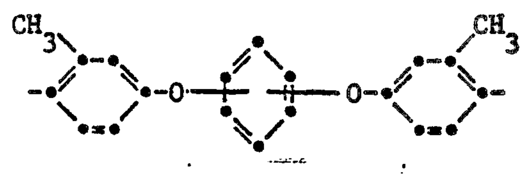

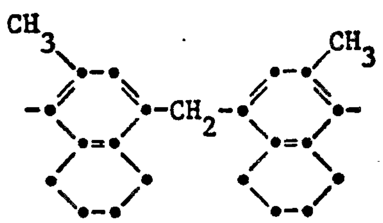 , 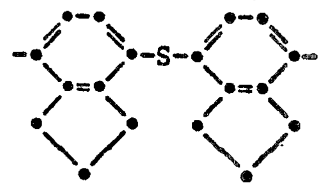 ,

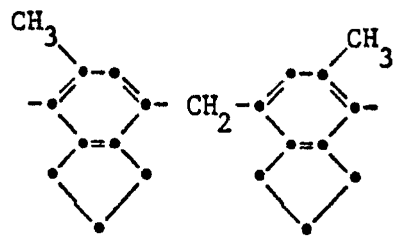,
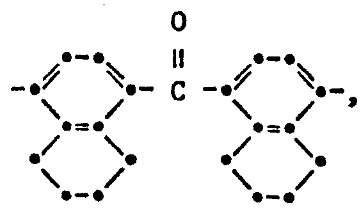

sowie

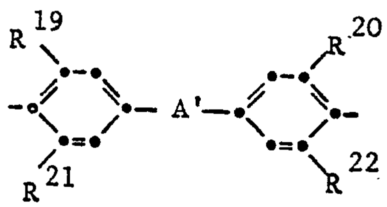,
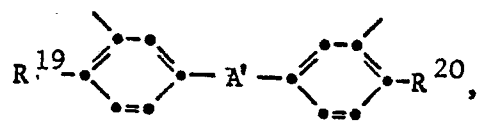

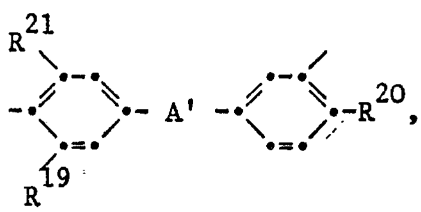
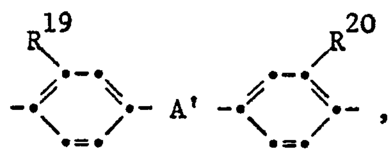

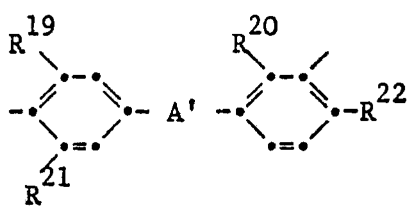
und
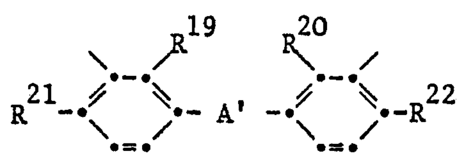

worin A', $R^{19}$, $R^{20}$, $R^{21}$ und $R^{22}$ die in nachfolgender Tabelle angegebenen Bedeutungen haben. Die drei vierfach substituierten Reste der voranstehenden Formeln können in jedem Kern durch Reste G und/oder H substituierte sein, wobei G und H die Bedeutung von $R^{19}$ bis $R^{22}$ haben können.

| A' | $R^{19}$ | $R^{20}$ | $R^{21}$ | $R^{22}$ |
|---|---|---|---|---|
| $CH_2$ | Methyl | Methyl | - | - |
| $CH_2$ | Methyl | Aethyl | - | - |
| $CH_2$ | Aethyl | Aethyl | - | - |
| $CH_2$ | Isopropyl | Isopropyl | - | - |
| $CH_2$ | Methoxymethyl | | - | - |
| $CH_2$ | Benzyl | Benzyl | - | - |
| $CH_2$ | Methyl | Methyl | H | H |
| $CH_2$ | Aethyl | Aethyl | H | H |
| $CH_2$ | Isopropyl | Isopropyl | H | H |
| $CH_2$ | Methoxymethyl | | H | H |
| $CH_2$ | Methyl | Aethyl | H | H |
| $CH_2$ | Methoxymethyl | | Methoxymethyl | |
| $CH_2$ | Methyl | Methyl | Methyl | Methyl |
| $CH_2$ | Aethyl | Aethyl | Aethyl | Aethyl |
| $CH_2$ | Methyl | Methyl | Aethyl | Aethyl |
| $CH_2$ | Aethyl | Aethyl | Isopropyl | Isopropyl |
| $CH_2$ | Isopropyl | Isopropyl | Isopropyl | Isopropyl |
| $CH_2$ | Isopropyl | Isopropyl | H | H |
| $CH_2$ | Methoxy | Methoxy | H | H |
| O | Methyl | Methyl | - | - |
| O | Aethyl | Aethyl | - | - |
| O | Methyl | Methyl | H | H |
| O | Methyl | Methyl | Methyl | Methyl |
| O | Methyl | Methyl | Aethyl | Aethyl |
| S | Methyl | Methyl | - | - |

| A' | $R^{19}$ | $R^{20}$ | $R^{21}$ | $R^{22}$ |
|---|---|---|---|---|
| S | Aethyl | Aethyl | - | - |
| S | Methyl | Methyl | H | H |
| S | Methyl | Methyl | Methyl | Methyl |
| S | Aethyl | Aethyl | Aethyl | Aethyl |
| S | Methyl | Methyl | Aethyl | Aethyl |
| CO | Methyl | Methyl | - | - |
| CO | Methyl | Methyl | H | H |
| CO | Methyl | Methyl | Methyl | Methyl |
| $SO_2$ | Methyl | Methyl | - | - |
| $SO_2$ | Methyl | Methyl | H | H |
| $SO_2$ | Methyl | Methyl | Methyl | Methyl |
| $SO_2$ | Aethyl | Aethyl | Methyl | Methyl |
| SO | Methyl | Methyl | - | - |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | - | - |
| $NCH_3$ | Methyl | Methyl | Methyl | Methyl |
| CONH | Methyl | Methyl | - | - |
| NH | Aethyl | Aethyl | H | H |
| NH | Methyl | Methyl | - | - |

| A' | $R^{19}$ | $R^{20}$ | $R^{21}$ | $R^{22}$ |
|---|---|---|---|---|
| $Si(Methyl)_2$ | Methyl | Methyl | - | - |
| $Si(Phenyl)_2$ | Methyl | Methyl | Methyl | Methyl |
| $Si(OMethyl)_2$ | Aethyl | Aethyl | - | - |
| $Si(OPhenyl)_2$ | Methyl | Methyl | H | H |
| Aethylen | Methyl | Methyl | - | - |
| Aethylen | Methyl | Methyl | Methyl | Methyl |
| Aethylen | Aethyl | Aethyl | H | H |
| Aethylen | Methyl | Methyl | - | - |
| Phenylen | H | H | Methyl | Methyl |
| Phenylen | Alkyl | Alkyl | - | - |
| $(CH_3)_2C<$ | Methyl | Methyl | H | H |
| $(CH_3)_2C<$ | Methyl | Methyl | Methyl | Methyl |

Falls X und Y in den Formeln I und II die $NR^5$-Gruppe oder X bzw. Y -O-oder -S- und das andere die $NR^5$-Gruppe bedeuten, kann R und eines der $R^5$ zusammen Alkylen mit 5-7 C-Atomen sein, an das die zweite $-NR^5$-Gruppe bzw. -O- oder -S- gebunden ist, oder R ist Methylen, Ethylen oder Propylen und die beiden $R^5$ der $NR^5$-Gruppen zusammen sind Ethylen oder Propylen. Die so definierten Reste leiten sich von heterocyclischen Diaminen oder Aminoalkoholen bzw. -thiolen ab. Beispiele hierfür sind: 3-Aminopyrrolidin, 3-Hydorxypyrrolidin, Imidazolidin, 3- oder 4-Aminopiperidin, 3- oder 4-Hydroxypiperidin und Piperazin.

Eine bevorzugte Gruppe von Polykondensation sind solche, in denen X und Y in den Formeln I und II für die $-NR^5$-Gruppe stehen und R und $R^4$ einen Rest der Formeln

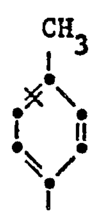 , 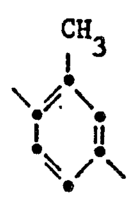 , 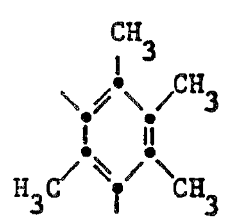 , 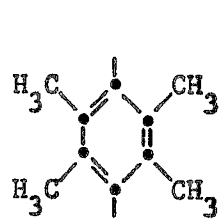

oder 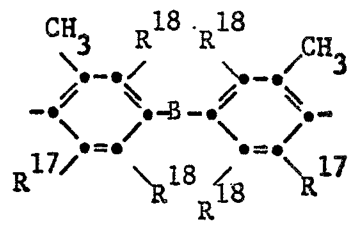

sind, worin B eine direkte Bindung, -O- und besonders $-CH_2-$ bedeutet, $R^{17}$ Ethyl oder besonders Methy ist,

oder verzweigtes Alkylen mit 6 bis 20 C-Atomen, das besonders in α-Stellung zur $-NR^5$-Gruppe verzweigt ist, und $R^{18}$ ein Wasserstoffatom, Methyl oder Ethyl darstellt.

Wenn X und Y in den Formeln I und II ein Sauerstoffatom bedeuten, ist in einer bevorzugten Ausführungsform R bzw. $R^4$ verzweigtes und besonders lineares Alkylen mit 2 bis 20, besonders 2 bis 12 C-Atomen, der zweiwertige Rest eines Polyoxyalkylens mit 2-100 Oxaalkyleneinheiten, z.B.

$-(OCH_2CH_2O)_u-$ oder 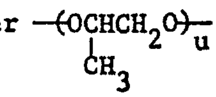 oder $-(OCH_2CH_2CH_2O)_u-$

mit u = 2 bis 100, Cyclohexylen,

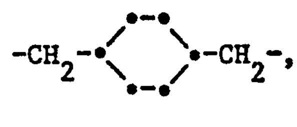

Benzylen, oder ein- oder zweikerniger Phenylenrest der Formeln

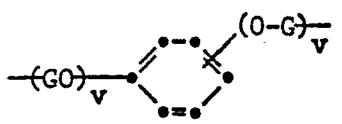 oder 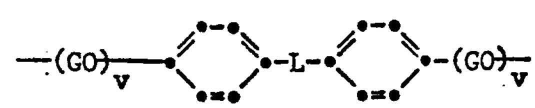

worin v 0 oder 1 ist, L eine direkte Bindung, -O-, -S-, -SO-, $-SO_2-$, CO, Methylen, Ethyliden, 1,1- oder 2,2-Propyliden, Butyliden oder Cyclohexyliden ist und G für Ethylen, 1,2-Propylen oder 2-Hydroxy-1,3-propylen steht. Die Phenylenreste können durch Alkyl oder Alkoxy mit 1 bis 4 C-Atomen oder Halogen, besonders Cl und Br, substituiert sein.

$R^3$ ist der zweiwertige Rest einer gesättigten organischen Dicarbonsäure. Der aliphatische Rest kann 2 bis 40, bevorzugt 2 bis 20 C-Atome und besonders 2-12 C-Atome enthalten. $R^3$ kann z.B. ein cycloaliphatischer Rest mit 5 bis 7 Ringkohlenstoffatomen oder lineares oder verzweigtes Alkylen mit 2 bis 12 C-Atomen sein. Als aromatischer Rest enthält $R^3$ bevorzugt 6-18 C-Atome und ist bevorzugt ein aromatischer Kohlenwasserstoffrest.

Als aliphatische Dicarbonsäuren kommen jene mit 2 bis 40 C-Atomen in Frage, z.B. Oxalsäure, Malonsäure, Dimethylmalonsäure, Bernsteinsäure, Pimelinsäure, Adipinsäure, Trimethyladipinsäure, Sebacinsäure, Azelainsäure und hydrierte Dimersäuren (Dimerisationsprodukte von ungesättigten aliphatischen Carbonsäuren wie Oelsäure), alkylierte Malon- und Bernsteinsäuren wie Octadecylbernsteinsäure.

Als cycloaliphatische Dicarbonsäuren kommen in Frage:
1,3-Cyclobutandicarbonsäure, 1,3-Cyclopentandicarbonsäure, 1,3- und 1,4-Cyclohexandicarbonsäure, 1,3- und 1,4- (Dicarboxylmethyl)-cyclohexan, 4,4'-Dicyclohexyldicarbonsäure.

Als geeignete aromatische Dicarbonsäuren kommen in Frage:
Terephthalsäure, Isophthalsäure, ö-Phthalsäure, 1,3-, 1,4-, 2,6- oder 2,7-Naphthalindicarbonsäure, 4,4'-Diphenyldicarbonsäure, 4,4'-Diphenylsulfoncarbonsäure, 1,1,3-Trimethyl-5-carboxyl-3-(p-carboxylphenyl)-indan, 4,4'-Diphenyletherdicarbonsäure, Bis-p-(carboxylphenyl)methan, Tetrabromterephthalsäure.

Aromatische und cycloaliphatische Orthodicarbonsäuren sowie Glutarsäuren und Bernsteinsäuren sind für Polyamide weniger geeignet, da sie unter dem Einfluss von primären Aminen zur Bildung von Imiden neigen.

Bevorzugt sind die aromatischen Dicarbonsäuren, unter ihnen besonders Terephthalsäure und Isophthalsäure und Dicarbonsäuren der Formel

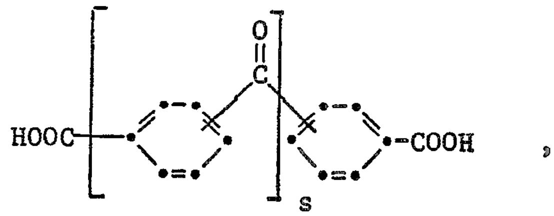

worin s für 1-6 steht.

In einer besonders bevorzugten Ausführungsform enthalten die erfindungsgemässen Polykondensate Strukturelemente der Formel

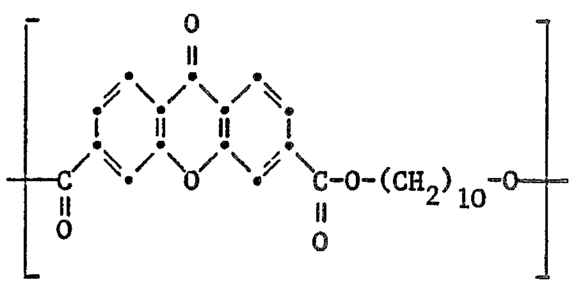

Die erfindungsgemässen Polykondensate können mittlere Molekulargewichte (Gewichtsmittel $\overline{M}w$) von mindestens 2 000, vorzugsweise mindestens 5 000 aufweisen. Die obere Grenze richtet sich im wesentlichen nach den gewünschten Eigenschaften, wie zum Beispiel deren Verarbeitbarkeit oder deren Löslichkeit. Sie kann bis zu 500.00, vorzugsweise bis zu 100.000 und besonders bis zu 50.000 betragen. Es kann sich ferner um statistische Polymere oder um Blockpolymere handeln. Sie werden nach üblichen Verfahren in hierfür vorgesehen Einrichtungen hergestellt. Die Polymeren sind vorzugsweise linear aufgebaut, können aber mit mindestens trifunktionellen Monomeren wie Triaminen, Triolen oder Tetrolen, die in kleinen Mengen zugesetzt werden, wenig verzweigt sein.

Ein weiterer Gegenstand ist ein Verfahren zur Herstellung von Polykondensaten mit Strukturelementen der Formeln I und/oder II, das dadurch gekennzeichnet ist, dass man Dicarbonsäuren der Formel IV

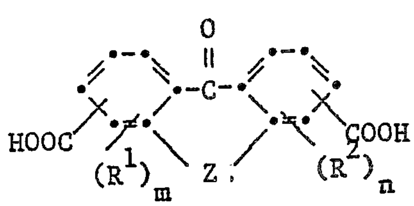

(IV),

worin Z, $R^1$, $R^2$, m und n die angegebene Bedeutung haben, oder Gemische dieser Säuren in einer Menge von mindestens 10 Mol.-%, bezogen auf das Polykondensat, gegebenenfalls zusammen mit einer Dicarbonsäure der Formel

$HOOC-R^3-COOH$ (V)

oder deren Polyester- oder Polyamid bildenden Derivate mit einem Diol, Dimercaptan, einem Diamin, einem Aminoalkohol, einem Aminomerkaptan, einem Hydroxymerkaptan der Formel VI oder mit Gemischen dieser Monomeren

HX - R - YH (VI),

worin R, $R^3$ und $R^5$ die angegebene Bedeutung haben und X und Y entweder für -O-, -S- oder für $-NHR^5$- oder X für -O- oder -S- und Y für $NHR^5$ stehen, polykondensiert.

Dicarbonsäuren der Formel IV sind teilweise bekannt. Anthrachinondicarbonsäuren sind z.B. bei N.K. Moshchinskaya, V.V. Kutsygina, L.I. Kovalevskaya et al., Ukr. Khim. Zh. (russ Ed.) 46(1), 77-80 (1980) beschrieben.

Aus der DE-A-2,344,814 sind Dicarbonsäuren des Anthrachinons, des Fluorenons und des Xanthons bekannt. Aus der DE-A-2,243,997 sind Dicarbonsäuren des Xanthons und des Acridons bekannt. Weitere Xanthon- und Acridondicarbonsäuren sind aus der US-A-3,859,307 und aus der US-A-4,250,182 bekannt.

Durch Hydrierung der Ketogruppen in Anthrachinondicarbonsäuren mit z.B. $NaBH_4$ erhält man die entsprechende Dihydroxyverbindung, die durch Behandlung mit Salzsäure am Rückfluss in Anthrondicarbonsäure überführt werden kann. Die $CH_2$-Gruppe der Anthrondicarbonsäure kann in bekannter Weise alkyliert und so in eine Verbindung gemäss Formel IV überführt werden, wo Z für $-CR^6R^7-$ steht und $R^6$ und $R^7$ die angegebene Bedeutung haben.

Zur Herstellung von Fluorenondicarbonsäure kann man z.B. Methylphenylmagnesiumbromid in Gegenwart von $CuCl_2$ dimerisieren und das gebildete Dimethylbiphenyl mit $COCl_2$ in Gegenwart von $AlCl_3$ zum Dimethylfluorenon umsetzen, das in bekannter Weise mit z . B. $HNO_3$ zur Dicarbonsäure oxidiert werden kann.

Xanthondicarbonsäure erhält man, indem man zunächst Dimethylphenylether mit $CCl_4$ in Gegenwart von $AlCl_3$ und anschliessender Hydrolyse mit verdünnter HCl zu Dimethylxanthon umsetzt, das in üblicher Weise zur Dicarbonsäure oxidiert wird, z.B. mit $HNO_3$.

Dicarbonsäuren mit Strukturelementen der Formel IV, worin Z S, SO, $SO_2$ oder NR bedeuten, sind z.B. auf folgendem Weg erhältlich: Bromtoluol wird mit $CCl_4$ in Gegenwart von $AlCl_3$ zum Bis-(Bromtoluyl)-dichlormethan umgesetzt.

Die Oxidation mit 20%iger $HNO_3$ führt zu

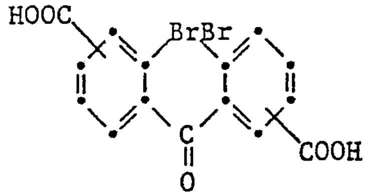

;

Die Umsetzung mit $Na_2S$ ergibt die Thioxanthondicarbonsäure, die in bekannter Weise zum Sulfoxid bzw. Sulfon oxidiert werden kann. Die Umsetzung mit $RNH_2$ führt zu Acridondicarbonsäuren.

Ein weiterer Gegenstand der Erfindung sind Dicarbonsäuren der Formel VII

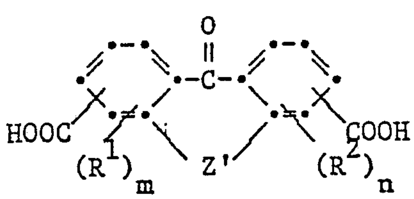

(VII),

worin Z' $-CH_2-$, -S-, -SO- oder $-CH^6R^7-$ bedeutet, wobei $R^6$ ein Wasserstoffatom, $C_1$-$C_{10}$-Alkyl, Phenyl, Naphthyl oder Phenyl($C_aH_{2a}$) mit a = 1-4 ist und $R^7$ die Bedeutung von $R^6$ mit Ausnahme der Bedeutung eines Wasserstoffatoms hat, $R^1$ und $R^2$ unabhänging voneinander für $C_1$-$C_{10}$-Alkyl, Halogen, -CN, $-NO_2$, $C_1$-$C_{12}$-Alkoxy, Phenoxy, Naphthoxy oder Phenyl-($C_aH_{2a}$) mit a = 1-4 stehen und m und n unabhängig voneinander 0, 1, 2 oder 3 sind, sowie die Säurederivate.

Säurederivate sind z.B. die Anhydride, Ester, Amide und Halogenide, besonders Chloride.

Bevorzugte Dicarbonsäuren der Formel VII sind solche, in denen die freien Bindungen in Meta- und Parastellung zur CO-Gruppe gebunden sind, m und n O sind und Z' eine direkte Bindung, $-CH_2-$, -O- oder -S- ist.

Geeignete Polyamid- bzw. Polyester bildende Derivate sind z.B. die Säureanhydride, Säureamide, Säurehalogenide und Säureester. Geeignete Herstellungsverfahren sind zum Beispiel die Lösungsmittelpolykondensation, die Schmelzkondensation und die Grenzflächenpolykondensation. Geeignete Lösungsmittel sind nachfolgend erwähnt.

Die Reaktionstemperaturen richten sich im wesentlich nach den Ausgangsmaterialien bzw. deren

Reaktivität. Sie kann -50 bis 350 °C, vorzugsweise 50 bis 300 °C betragen. Ferner kann die Polykondensation bei Normaldruck oder Unterdruck durchgeführt werden. Vorteilhaft wird bei der Kondensation entstehendes Wasser, Alkohol oder Amin während des Verfahrens aus dem Reaktionsgemisch entfernt bzw. entstehende Halogenwasserstoffe, z.B. HCl oder HBr, durch Zugabe geeigneter Mittel wie tertiäre Amine oder Epoxide gebunden.

Bei der Herstellung von Polyestern wird vorteilhaft ebenfalls in zwei Stufen verfahren, indem man in einer ersten stufe eine Veresterung bzw. Umesterung mit dem Diol oder Dimerkaptan durchführt und anschliessend die Polykondensation bevorzugt in der Schmelz unter Entfernung des gebildeten überschüssigen Diols bzw. Merkaptans fortsetzt, bis die gewünschte Viskosität erreicht ist.

Bei den erfindungsgemässen Polykondensaten handelt es sich um Polymere, die direkt durch Einwirkung von Strahlung vernetzt werden können. Sie eignen sich zur Herstellung von Formkörpern, Folien, Fasern und zur Beschichtung von Substraten, für den Oberflächenschutz oder zur Erzeugung von Reliefabbildungen, wobei durch Bestrahlung die Eigenschaften der Polykondensate modifiziert werden können. Ein Teil der erfindungsgemässen Polykondensate sind Thermoplaste, die nach den für diese Polymerklasse üblichen Verfahren verarbeitet werden können. Die hochschmelzenden insbesondere vollaromatischen Polykondensate werden bevorzugt aus Lösung verarbeitet.

Ein bevorzugter Anwendungsbereich ist die Verwendung zur Beschichtung von Oberflächen und die Herstellung von Reliefabbildungen auf solchen beschichteten Substraten, was ein weiterer Gegenstand vorliegender Erfindung ist. Es ist besonders vorteilhaft, dass zur Erzielung gewünschter Eigenschaften die erfindungsgemässen Polykondensate für bestimmte Anforderungen bei der Anwendung durch Auswahl unterschiedlicher Monomerer und/oder durch Abmischung verschiedener Polykondensate entsprechend eingestellt werden können.

Zur Herstellung des erfindungsgemässen beschichteten Materials löst man ein Polykondensat oder Gemische davon zweckmässig in einem geeigneten organischen Lösungsmittel, gegebenenfalls unter Erwärmen. Geeignete Lösungsmittel sind z.B. polare, aprotische Lösungsmittel, die alleine oder in Mischungen aus mindestens zwei Lösungsmitteln verwendet werden können. Beispiele sind: Ether wie Dibutylether, Tetrahydrofuran, Dioxan, Ethylenglykol, Dimethylethylenglykol, Dimethyldiethylenglykol, Diethyldiethylenglykol, Dimethyltriethylenglykol, halogenierte Kohlenwasserstoffe wie Methylenchlorid, Chloroform, 1,2-Dichlorethan, 1,1,1-Trichlorethan, 1,1,2,2-Tetrachlorethan, Carbonsäureester und Lactone wie Essigsäureethylester, Propionsäuremethylester, Benzoesäureethylester, 2-Methoxyethylacetat, γ-Butyrolacton, o-Valerolacton und Pivalolacton, Carbonsäureamide und Lactame wie Formamid, Acetamid, N-Methylformamid, N,N-Dimethylformamid, N,N-Diethylformamid, N,N-Dimethylacetamid, N,N-Diethylacetamid, γ-Butyrolactam, ε-Caprolactam, N-Methylpyrrolidon, N-Acetylpyrrolidon, N-Methylcaprolactam, Tetramethylharnstoff, Hexamethylphosphorsäuretriamid, Sulfoxide wie Dimethylsulfoxid, Sulfone wie Dimethylsulfon, Diethylsulfon, Trimethylensulfon, Tetramethylensulfon, Trimethylamin, Triethylamin, N-Methylpyrrolidin, N-Methylpiperidin, N-Methylmorpholin, substituierte Benzole wie Chlorbenzol, Nitrobenzol, Phenole oder Kresol.

Ungelöste Anteile können durch Filtration, bevorzugt einer Druckfiltration, entfernt werden. Die Konzentration an Polymer im so erhaltenen Beschichtungsmittel beträgt vorzugsweise nicht mehr als 5o Gew.-%, besonders nicht mehr als 30 Gew.-% und insbesondere nicht mehr als 20 Gew.-%, bezogen auf die Lösung. Die Lösungen sind lagerstabil.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente und Haftvermittler. Ferner können auch, falls erwünscht, zusätzlich Sensibilisatoren, wie z.B. Thioxanthonderivate oder Benzophenonderivate einverleibt werden, um die Lichtempfindlichkeit noch weiter zu erhöhen.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca. 500 µm und mehr, bevorzugt von 0,5 bis 500 µm und besonders von 1 bis 50 µm aufweisen.

Die strahlungsempfindliche Schicht im erfindungsgemässen Material kann durch Einwirkung von Strahlung vernetzt werden.

Die Photostrukturierung bzw. Photovernetzung kann durch energiereiche Strahlung hervorgerufen werden, z.B. durch Licht insbesondere im UV-Bereich, durch Röntgenstrahlen, Laserlicht, Elektronenstrahlen

usw. Das erfindungsgemässe Material eignet sich hervorragend zur Herstellung von Schutzfilmen, Passivierlacken, und als photographisches Aufzeichnungsmaterial für thermostabile Reliefabbildungen.

Ein weiterer Gegenstand der Erfindung ist diese Verwendung. Anwendungsgebiete sind z.B. Schutz-, Isolier- und Passivierlacke in der Elektrotechnik und Elektronik, Photomasken für die Elektronik, den Textildruck und das graphische Gewerbe, Aetzresiste zur Herstellung gedruckter Schaltungen und Druckplatten und integrierter Schaltkreise, Relais für die Herstellung von Röntgenmasken, als Lötstoplack, als Dielektrikum für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten.

Die photographische Erzeugung der Reliefstruktur erfolgt durch bildmässige Belichtung durch eine Photomaske, anschliessende Entwicklung unter Entfernung der unbelichteten Anteile mit eine Lösungsmittel oder einem Lösungsmittelgemisch, wonach gegebenenfalls das erzeugte Bild durch eine thermische Nachbehandlung stabilisiert werden kann.

Ein weiterer Gegenstand der Erfindung ist ein solches Verfahren zum Aufbringen von Reliefstrukturen. Als Entwickler sind z.B. die zuvor erwähnten Lösungsmittel geeignet.

Die Polymerschicht des erfindungsgemässen Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch gute Haftfestigkeit und thermische, mechanische und chemische Widerstandsfähigkeit aus. Bei thermischen Nachbehandlungen wird nur ein geringer Schwund beobachtet. Ferner können Zusätze zur Erzeugung bzw. Steigerung der Lichtempfindlichkeit vermieden werden. Das Material ist lagerstabil, ist aber vor Lichteinwirkung zu schützen.

Die nachfolgenden Beispiele erläutern die Erfindung näher.

A. Herstellung der Ausgangsprodukte

Beispiel 1: Thioxanthon-10,10-dioxid-2,6-dicarbonsäurediphenylester

a) Thioxanthon-10,10-dioxid-2,6-dicarbonsäure

56 g 2-Methyl-thioxanthon-6-dicarbonsäure werden in 600 ml 2o%iger Salpetersäure suspendiert und 24 Stunden im Autoklaven auf 180° C erhitzt. Das Reaktionsprodukt wird filtriert, mit Wasser gewaschen und getrocknet.

| Elementaranalyse: | | | | |
|---|---|---|---|---|
| berechnet: | C 54,22% | H 2,43% | O 33,71% | S 9,65% |
| gefunden: | C 54,2% | H 2,6% | O 33,1% | S 9,5% |

b) Thioxanthon-10,10-dioxid-2,6-dicarbonsäuredichlorid

Eine Suspension von 38 g Disäure gemäss a) wird in 200 ml Thionylchlorid und 1 ml Dimethylformamid während 5 Stunden unter Rückfluss gekocht. Dann wird das überschüssige Thionylchlorid abgedampft und der Rückstand zweimal aus Toluol umkristallisiert. Ausbeute: 28 g. Massenspektrum: m/e = 368 (5%, $M^+$) und 333 (100%, $M^+$ - Cl).

c) Thioxanthon-10,10-dioxid-2,6-dicarbonsäurediphenylester

Zu einer im Eisbad gekühlten Mischung von 28 g Säurechlorid gemäss b) und 23 g Phenol in 200 ml Chloroform werden 30 ml Triethylamin zugetropft. Die Mischung wird 20 Stunden gerührt und nach Verdünnen mit weiteren 200 ml Chloroform mit Natriumcarbonat-Lösung gewaschen. Nach Abdestillieren des Lösungsmittels wird der Rückstand aus Chloroform umkristallisiert. Ausbeute: 30,9 g. Schmelzpunkt: 228-230° C.

| Elementaranalyse: | | | | |
|---|---|---|---|---|
| berechnet: | C 66,94% | H 3,33% | O 23,12% | S 6,62% |
| gefunden: | C 67,2% | H 3,5% | O 22,6% | S 6,7% |

Beispiel 2: Xanthon-3,6-dicarbonsaurediphenylester

15,7 g 3,6-Dimethylxanthon (J.B. Chazan und G. Ourisson, Bull.Soc. Chim. France 1968, 1384) werden in 450 ml 2o%iger Salpetersäure suspendiert und 20 Stunden lang auf 180 °C erhitzt. Nach Abkühlen, Filtrieren, Waschen mit Wasser und Trocknen werden 12,7 g Xanthon-3,6-dicarbonsäure erhalten.

Eine Mischung von 12,5 g Dicarbonsäure, 120 ml Thionylchlorid und 1 ml Dimethylformamid wird 2,5 Stunden lang unter Rückfluss erhitzt. Dann werden alle flüchtigen Anteile abdestilliert und der Rückstand im Vakuum getrocknet. Die Substanz wird nun in 250 ml Chloroform supsendiert und im Eisbad abgekühlt. Nach Zugabe von 16 g Phenol werden 20 g Triethylamin im Verlaufe von 1,5 Stunden zugetropft und 16 Stunden bei Raumtemperatur gerührt. Die Lösung wird auf 150 ml eingeengt, filtriert und der Filterrückstand aus Toluol umkristallisiert. Dabei werden 7 g Xanthon-3,6-dicarbonsäurediphenylester erhalten. Schmelzpunkt: 241-242 °C.

| Elementaranalyse: | | | |
|---|---|---|---|
| berechnet: | C 74,31% | H 3,70% | O 22,0% |
| gefunden: | C 74,2% | H 4,0% | O 21,6% |

B. Herstellung der Polymeren

Die reduzierte Viskosität der Polyamide und Polyester ($\eta_{red}$) wird jeweils in 0,5%iger Lösung in m-Kresol bei 25 °C bestimmt und die Glasumwandlungstemperatur ($T_g$) oder die Schmelztemperatur ($T_m$) in einem Differential Scanning Calorimeter (DCS) gemessen.

Beispiel 3: Ein Gemisch von 4,42 g Decandiol (1,6) (0,025 Mol) und 2,77 g (0,0064 Mol) Xanthon-3,6-dicarbonsäurediphenylester wird unter Inertatmosphäre in Gegenwart von ca. 2,5 mg Titantetraisopropylat als Katalysator unter Rühren auf 220 °C erhitzt. Nach 4 Stunden wird der Druck von Normaldruck auf unter 0,1 Torr reduziert und die Schmelze 1,5 Stunden weitergerührt. Beim anschliessenden Abkühlen erstarrt die Schmelze.

$\eta_{red}$: 0,20 dl/g  $T_m$: 88 °C ($\Delta H$ = 37 J/g).

Beispiel 4: Ein Gemisch von 1,55 g (0,006 Mol) 1-Isopropyl-10,10-dimethyl-1,11-diaminoundecan und 2,92 g Thioxanthon-10,10-dioxid-2,6-dicarbonsäurediphenylester (0,006 Mol) in 10 g Phenol als Lösungsmittel wird unter Intergas auf 190 °C aufgeheizt und während 2,5 Stunden bei dieser Temperatur gerührt. Dann wird die Temperatur auf 220 °C gesteigert und weitere 6 Stunden gerührt. Nach dem Abkühlen wird das Polyamid durch Eingiessen in Alkohol ausgefällt und isoliert.

$\eta_{red}$: 0,14 dl/g  Tg: 90 °C.

Beispiel 5: In einem zylindrischen Rührgefäss mit Rührer, Tropftrichter, Thermometer, Gaseinleitungs- und Gasableitungsrohr werden je 0,01 Mol 3,3',5,5'-Tetramethyl-4,4'-diaminodiphenylmethan und 2,4-Diamino-3,5-diethyltoluol in 35 ml N-Methylpyrrolidon (NMP) unter Stickstoffatmosphäre auf -15 °C abgekühlt. In die Lösung werden nun 6,67 g (0,02 Mol) Anthrachinon-2,6(2,7)-dicarbonsäuredichlorid eingebracht. Nach 5 Minuten wird die Kühlung entfernt und die Lösung 5 Stunden lang gerührt. Nach Zugabe von 0,8 ml Propylenoxid wird eine Stunde weitergerührt. Die Isolierung des Polyamids erfolgt durch Fällen mit 500 ml Wasser in einem Haushaltmixer, Filtrieren, Waschen mit Wasser und Trocknen bei 80 °C im Vakuum.

Tg: 300 °C.

C. Applikationsbeispiel (Reliefbilderzeugung)

Auf einer einseitig kupfer-kaschierten Kunststoffplatte wird ein dünner Polymerfilm erzeugt, indem eine 5%ige Lösung des Polymeren aufgeschleudert wird und das Lösungsmittel anschliessend in einem Umluftofen entfernt wird. Als Lösungsmittel wird in den meisten Fällen NMP verwendet.

Die so beschichtete Platte wird durch eine Photomaske bei Raumtemperatur mit einer 1000-Watt UV-Lampe aus 18 cm Entfernung belichtet. Die belichtete Platte wird anschliessend mit einem Lösungsmittel entwickelt, wobei die unbelichteten Anteile weggelöst werden (Entwickler: Mischung von $\gamma$-Butyrolacton und Propylenglykolcarbonat). Die Sichtbarmachung des Reliefbildes erfolgt durch Wegätzen der freigelegten

Kupferschicht mit $FeCl_3$-Lösung.

Im folgenden Abschnitt sind die Belichtungszeiten zum Erhalt einer vollständigen Abbildung für die in den Beispielen 3 bis 5 beschriebenen Polymeren wiedergegeben.

| Beispiel | 3 | 4 | 5 |
|---|---|---|---|
| Sekunden | 60 | 240 | 120 |

## Ansprüche

1. Verfahren zur Herstellung von vernetzten Polymeren, dadurch gekennzeichnet, dass man strahlungsempfindliche lineare gesättigte Homo- und Copolykondensate mit energiereicher Strahlung bestrahlt, wobei besagte Polykondensate ausgewählt sind aus der Gruppe bestehend aus Polyestern, Polyesteramiden und Polyamiden, die mindestens 10 Mol%, bezogen auf das Polykondensat, eines wiederkehrenden Strukturelements der Formel I

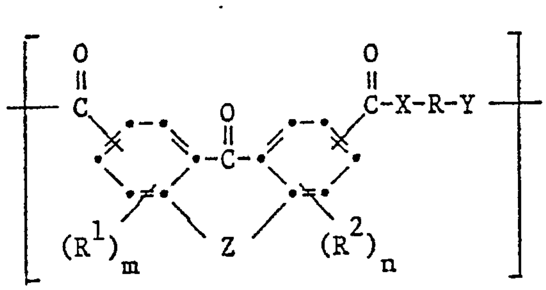

(I)

und im Fall von Copolykondensaten zusätzlich wiederkehrenden Strukturelemente der Formel II enthalten,

$$-\overset{O}{\overset{\|}{C}}-R^3-\overset{O}{\overset{\|}{C}}-X-R^4-Y- \qquad \text{(II)},$$

worin m und n unabhängig voneinander für eine Zahl von 0 bis 3 stehen, X und Y unabhängig voneinander für -S-, -O- oder $NR^5$- stehen, Z eine direkte Bindung, $-CH_2-$, -O-, -S-, $-SO_2-$, -CO-, $-NR^6-$ oder $-CR^6R^7-$ bedeutet, wobei $R^6$ ein Wasserstoffatom, $C_1$-$C_{10}$-Alkyl, Phenyl, Naphthyl oder Phenyl-($C_aH_{2a}$) mit a = 1 bis 4 ist und $R^7$ die Bedeutung von $R^6$ mit Ausnahme der Bedeutung eines Wasserstoffatomes hat, $R^1$ und $R^2$ unabhängig voneinander für $C_1$-$C_{10}$-Alkyl, Halogen, -CN, $-NO_2$, $C_1$-$C_{12}$-Alkoxy, Phenoxy, Naphthoxy oder Phenyl-($C_aH_{2a}$) mit a = 1-4 stehen,
R einen unsubstituierten oder substituierten zweiwertigen aliphatischen, cycloaliphatischen, araliphatischen oder aromatischen Rest bedeutet, und falls X und Y die Gruppe $-NR^5-$ sind, R und eines der $R^5$ zusammen Alkylen mit 5 bis 7 C-Atomen, an das die zweite $-NR^5$-Gruppegebunden ist, oder R Methylen, Ethylen oder Propylen und die beiden $R^5$ der $NR^5$-Gruppen zusammen Ethylen oder Propylen oder falls X oder Y -S- oder -O- und das anders $NR^5$- sind, R und $R^5$ zusammen Alkylen mit 5-7 C-Atomen bedeuten,
$R^4$ unabhängig die gleiche Bedeutung wie R hat,
$R^3$ ein zweiwertiger gesättigter aliphatischer oder aromatischer Rest ist und
$R^5$ ein Wasserstoffatom, Alkyl, Cycloalkyl, Aryl, Aralkyl oder Alkaralkyl bedeutet.

2. Verfahren zur Herstellung von Oebrflächenheschichtungen oder Reliefabbildungen umfassend die Schritte

i) Beschichten eines Substrates mit einem Polykondensat gemäss Anspruch 1,
ii) Belichten der Polykondensatschicht mit energiereicher Strahlung, wobei das Belichten direkt oder bildmässig erfolgen kann,
iii) Entfernen der unbelichteten Anteile der Polykondensatschicht durch Entwicklung mit einem Lösungsmittel oder einem Lösungsmittelgemisch, und
iv) gegebenenfalls Stabilisieren des erzeugten Bildes durch thermische Nachbehandlung.

**3.** Strahlungsempfindliche lineare gesättigte Homo- und Copolykondensate aus der Gruppe der Polyester, Polyesteramide und Polyamide enthaltend mindestens 10 Mol%, bezogen auf das Polykondensat eines wiederkehrenden Strukturelements der Formel I

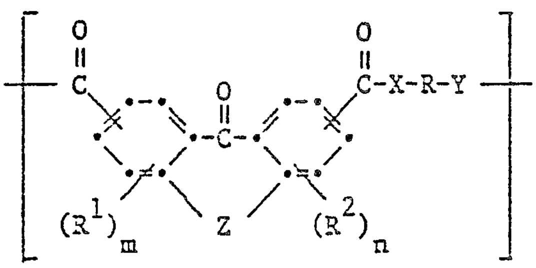

(I)

und im Fall von Copolykondesaten zusätzlich wiederkehrende Strukturelementen der Formel II

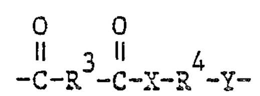

(II),

worin m und n unabhängig voneinander für eine Zahl von 0 bis 3 stehen, X und Y unabhängig voneinander für -S-, -O- oder -$NR^5$- stehen, Z -$CH_2$-, -O-, -S-, -SO-, $SO_2$, -CO-, -$NR^6$- oder -$CR^6R^7$- bedeutet, wobei $R^6$ ein Wasserstoffatom, $C_1$-$C_{10}$-Alkyl, Phenyl, Naphthyl oder Phenyl-($C_aH_{2a}$) mit a = 1 bis 4 ist und $R^7$ die Bedeutung von $R^6$ mit Ausnahme der Bedeutung eines Wasserstoffatomes hat, $R^1$ und $R^2$ unabhängig voneinander für $C_1$-$C_{10}$-Alkyl, Halogen, -CN, -$NO_2$, $C_1$-$C_{12}$-Alkoxy, Phenoxy, Naphthoxy oder Phenyl-($C_aH_{2a}$) mit a = 1-4 stehen,
R einen unsubstituierten oder substituierten zweiwertigen aliphatischen, cycloaliphatischen, araliphatischen oder aromatischen Rest bedeutet, und falls X und Y die Gruppe -$NR^5$- sind, R und eines der $R^5$ zusammen Alkylen mit 5 bis 7 C-Atomen, an das die zweite $NR^5$-Gruppe gebunden ist, oder R Methylen, Ethylen oder Propylen und die beiden $R^5$ der $NR^5$ -Gruppen zusammen Ethylen oder Propylen oder falls X oder Y -S- oder -O- und das andere $NR^5$- sind, R und $R^5$ zusammen Alkylen mit 5-7 C-Atomen bedeuten,
$R^4$ unabhängig die gleiche Bedeutung wie R hat,
$R^3$ ein zweiwertiger gesättigter aliphatischer oder aromatischer Rest ist und
$R^5$ ein Wasserstoffatom, Alkyl, Cycloalkyl, Aryl, Aralkyl oder Alkaralkyl bedeutet.

**4.** Verfahren gemäss Anspruch 1 oder 2 oder Polykondensate gemäss Anspruch 3, dadurch gekennzeichnet, dass die Strukturelemente der Formel I zu mindestens 50 Mol.-%, bevorzugt zu mindestens 70 Mol.-%` und insbesondere zu mindestens 90 Mol.-% im Copolykondensat enthalten sind.

**5.** Verfahren gemäss Anspruch 1 oder 2 oder Polykondensate gemäss Anspruch 3, dadurch gekennzeichnet, dass $R^5$ Alkyl mit 1 bis 6 C-Atomen, Phenyl oder Benzyl und besonders ein Wasserstoffatom ist.

**6.** Verfahren gemäss Anspruch 1 oder 2 oder Polykondensate gemäss Anspruch 3, dadurch gekennzeichnet, dass die Carbonylgruppen in den Strukturelementen der Formel I in Metastellung und besonders in Parastellung zur Carbonylgruppe im Ring gebunden sind.

**7.** Verfahren gemäss Anspruch 1 oder 2 oder Polykondensate gemäss Anspruch 3, dadurch gekennzeichnet, dass R und $R^4$ als aliphatischer Rest 2 bis 30 C-Atome, als cycloaliphatischer Rest 5 bis 8 Ring-C-Atome, als araliphatischer Rest 7 bis 30 C-Atome und als aromatischer Rest 6 bis 30 C-Atome

enthalten.

8. Verfahren gemäss Anspruch 1 oder 2 oder Polykondensate gemäss Anspruch 3, dadurch gekennzeichnet, dass X und Y in den Formeln I und II für die Gruppe $-NR^5-$ stehen und der aliphatische oder araliphatische Rest 6 bis 22 C-Atome enthält oder X und Y in den Formeln I und II für -O- stehen und der aliphatische Rest 2 bis 12 C-Atome enthält.

9. Verfahren gemäss Anspruch 1 oder 2 oder Polykondensate gemäss Anspruch 3, dadurch gekennzeichnet, dass R und $R^4$ unabhängig voneinander als aliphatischer Rest lineares oder verzweigtes Alkylen sind, das durch Sauerstoffatome, NH, $NR^a$ oder $^+NR^a_2$ a$G^-$, worin $R^a$ Alkyl mit 1 bis 12 C-Atomen oder Cycloalkyl mit 5 oder 6 Ring-C-Atomen, Phenyl oder Benzyl ist und G das Anion einer Protonensäure ist, Cyclohexylen, Naphthylen, Phenylen oder Hydantoine unterbrochen sein kann; als cycloaliphatischer Rest unsubstituiertes oder durch Alkyl substituiertes Mono- oder bicyclisches Cycoalkylen mit 5 bis 7 Ring-C-Atomen; als araliphatischer Rest unsubstituiertes oder am Aryl durch Alkyl substituiertes Aralkylen ist, wobei der Alkylenrest linear oder verzweigt sein kann; und als aromatischer Rest ein unsubstituierter oder durch Alkyl, Alkoxy, Alkoxyalkyl, Trimethylen oder Tetramethylen substituierter Kohlenwasserstoffrest oder Pyridinrest sind.

10. Verfahren oder Polykondensate gemäss Anspruch 9, dadurch gekennzeichnet, dass R und $R^4$ als aliphatischer Rest lineares oder verzweigtes Alkylen mit 2 bis 30 C-Atomen, $-(CH_2)_x-R^8-(CH_2)_y-$, worin $R^8$ Phenylen, Naphthylen, Cyclopentylen oder Cyclohexylen und x und y unabhängig voneinander eine Zahl von 1, 2 oder 3 sind,

$$-R^9-(OR^{10})_p-O-R^9-,$$

worin $R^9$ Ethylen, 1,2-Propylen, 1,3-Propylen oder 2-Methyl-1,3-propylen $R^{10}$ Ethylen, 1,2-Propylen, 1,2-Butylen, 1,3-Propylen oder 1,4-Butylen und p eine Zahl von 1 bis 100 sind, oder

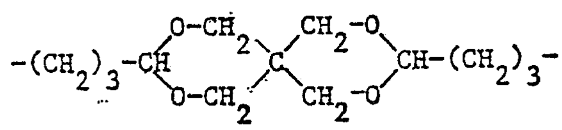

ist.

11. Verfahren oder Polykondensate gemäss Anspruch 9, dadurch gekennzeichnet, dass R und $R^4$ als cycloaliphatischer Rest solche der Formeln

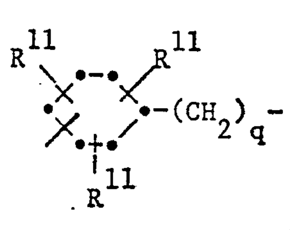

oder

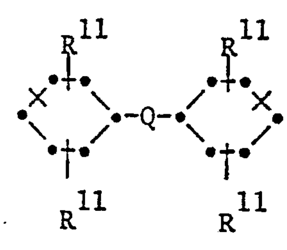

sind, worin q 0 oder 1 ist, $R^{11}$ unabhängig Wasserstoff oder Alkyl mit 1 bis 6 C-Atomen bedeutet und Q für eine direkte Bindung, O, S, SO, Alkylen mit 1 bis 3 C-Atomen oder Alkyliden mit 2 bis 6 C-Atomen steht.

12. Verfahren oder Polykondensate gemäss Anspruch 9, dadurch gekennzeichnet, dass R und $R^4$ als aromatischer Rest durch Alkyl, Alkoxy oder Alkoxyalkyl mit 1 bis 6 C-Atomen oder zwei benachbarte C-Atome des aromatischen Restes durch Trimethylen oder Tetramethylen substituiert sind.

**13.** Verfahren oder Polykondensate gemäss Anspruch 12, dadurch gekennzeichnet, dass X und Y in den Formeln I und II die Gruppe -$NR^5$- bedeuten und ein oder zwei Substituenten in Orthostellung zur -$NR^5$-Gruppe gebunden sind.

**14.** Verfahren oder Polykondensate gemäss Anspruch 9, dadurch gekennzeichnet, dass der araliphatische Rest der Formel

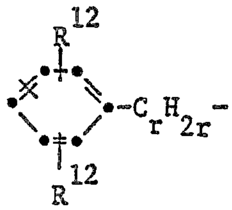

entspricht, worin die $R^{12}$ unabhängig ein Wasserstoffatom oder Alkyl mit 1 bis 6 C-Atomen und r ganze Zahlen von 1 bis 16 bedeuten.

**15.** Verfahren oder Polykondensate gemäss Anspruch 14, dadurch gekennzeichnet, dass die freie Bindung in p-Stellung zur $C_rH_{2r}$-Gruppe steht und ein oder beide $R^{12}$ als Alkyl in o-Stellung zur freien Bindung gebunden sind.

**16.** Verfahren oder Polykondensate gemäss Anspruchs 9, dadurch gekennzeichnet, dass der aromatische Rest den Formeln

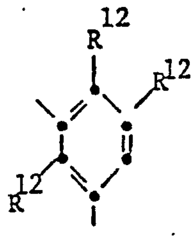 , 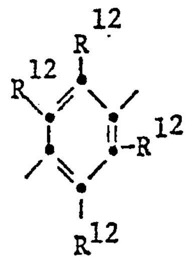 , 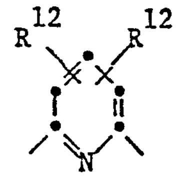 ,

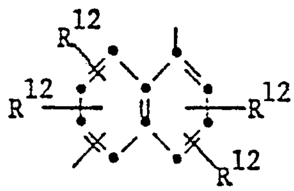 , 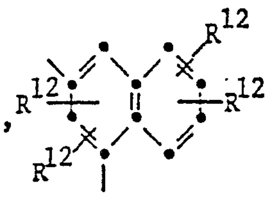 , 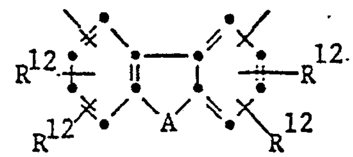 ,

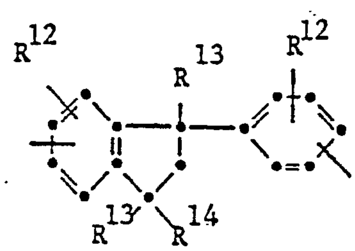 oder

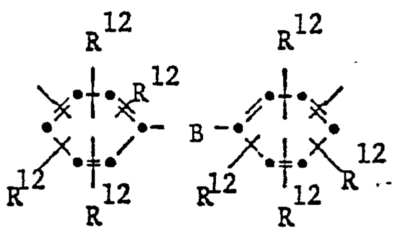

entspricht, worin $R^{12}$ ein Wasserstoffatom oder $R^{12}$ im Falle der Monosubstitution Alkyl mit 1 bis 6 C-Atomen und die anderen $R^{12}$ Wasserstoff sind, und im Falle der Di-, Tri- oder Tetrasubstitution zwei $R^{12}$ Alkyl mit 1 bis 6 C-Atomen und die anderen $R^{12}$ ein Wasserstoffatom oder Alkyl mit 1 bis 6 C-Atomen sind oder im Falle der Di-, Tri- oder Tetrasubstitution zwei vicinale $R^{12}$ Phenylring für Trimethylen oder Tetramethylen und die anderen $R^{12}$ für ein Wasserstoffatom oder Alkyl mit 1 bis 6 C-Atomen stehen, A für O, S, NH, CO oder $CH_2$ steht, $R^{13}$ ein Wasserstoffatom oder Alkyl mit 1 bis 5 C-Atomen und $R^{14}$ Alkyl mit 1 bis 5 C-Atomen darstellt, und B eine direkte Bindung, O, S, SO, $SO_2$, CO,

$$\overset{O}{\overset{\|}{C}}O,\ \overset{O}{\overset{\|}{C}}NR^{15},$$

$NR^{15}$ , CONH, NH, $R^{15}$ $SiR^{16}$ , $R^{15}$ $OSiOR^{16}$ , Alkylen mit 1 bis 6 C-Atomen, Alkenylen oder Alkyliden mit 2 bis 6 C-Atomen, Phenylen oder Phenyldioxyl bedeutet, worin $R^{15}$ und $R^{16}$ unabhängig voneinander Alkyl mit 1 bis 6 C-Atomen oder Phenyl bedeuten.

**17.** Verfahren oder Polykondensate gemäss Anspruch 16, dadurch gekennzeichnet, dass der aromatische Rest

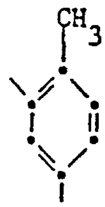, 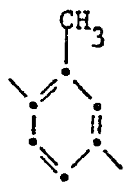, 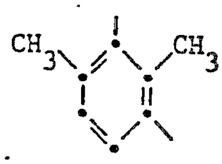, 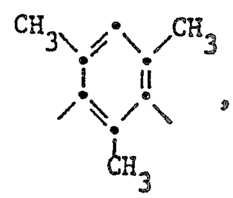, 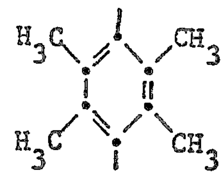,

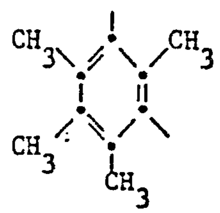 oder 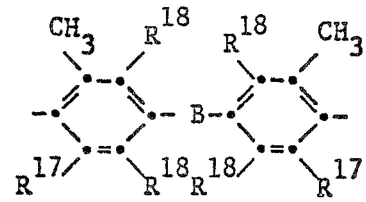

ist, worin B eine direkte Bindung, O und besonders $CH_2$ bedeutet und $R^{17}$ und $R^{18}$ unabhängig voneinander ein Wasserstoffatom Methyl oder Ethyl darstellen.

**18.** Verfahren gemäss Anspruch 1 oder 2 oder Polykondensate gemäss Anspruch 3, dadurch gekennzeichnet, dass X und Y in den Formeln I und II für die $-NR^5$-Gruppe stehen und R und $R^4$ einen Rest gemäss Anspruch 15 bedeuten, worin $R^{17}$ Methyl oder Ethyl und $R^{18}$ H, Methyl oder Ethyl sind; oder X und Y bedeuten in den Formeln I und II verzweigtes Alkylen mit 6 bis 20 C-Atomen, das bevorzugt in $\alpha$-Stellung zur $-NR^5$-Gruppe verzweigt ist.

**19.** Verfahren gemäss Anspruch 1 oder 2 oder Polykondensate gemäss Anspruch 3, dadurch gekennzeichnet, dass $R^3$ in Formel II lineares oder verzweigtes Alkylen mit 2 bis 12 C-Atomen, Cycloalkylen mit 5 bis 7 Ringkohlenstoffatomen oder ein aromatischer Kohlenwasserstoffrest mit 6 bis 18 C-Atomen ist.

**20.** Verfahren oder Polykondensate gemäss Anspruch 19, dadurch gekennzeichnet, dass $R^3$ in Formel II ein Strukturelement der Formel III

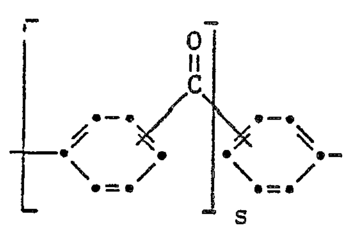 (III),

worin s für 1 = 6 steht, ist.

**21.** Verfahren gemäss Anspruch 1 oder 2 oder Polykondensate gemäss Anspruch 3, dadurch gekennzeichnet, dass Z in Formel I für -CO-, $SO_2$- oder -O- steht.

**22.** Verfahren gemäss Anspruch 1 oder 2 oder Polykondensate gemäss Anspruch 3, dadurch gekennzeichnet, dass sie das Strukturelement

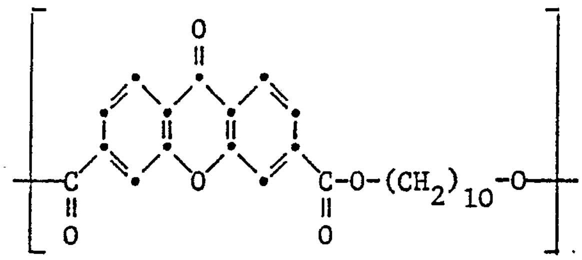

enthalten.

**23.** Verfahren zur Herstellung von Polykondensaten gemäss Anspruch 3, dadurch gekennzeichnet, dass man Dicarbonsäuren der Formel IV

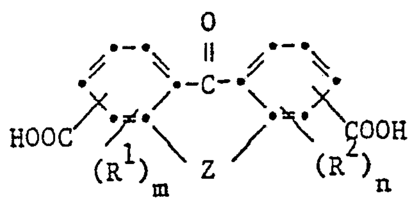

(IV),

worin Z, $R^1$ $R^2$, m und n die in Anspruch 3 angegebene Bedeutung haben, oder Gemische dieser Säuren in einer Menge von mindestens 10 Mol.-%, bezogen auf das Polykondensat, gegebenenfalls zusammen mit einer Dicarbonsäure der Formel V

$HOOC\text{-}R^3\text{-}COOH$ (V)

oder deren Polyester- oder Polyamid bildenden Derivate mit einem Diol, Dimercaptan, einem Diamin, einem Aminoalkohol, einem Aminomerkaptan, einem Hydroxymerkaptan der Formel VI oder mit Gemischen dieser Monomeren

Hx - R - YH (VI),

worin X und Y entweder für -O-, -S- oder für $-NHR^5$ - oder X für -O-oder -S- und Y für $NHR^5$ stehen und R, $R^3$ und $R^5$ die angegebene Bedeutung haben, polykondensiert.

**24.** Dicarbonsäuren der Formel VII

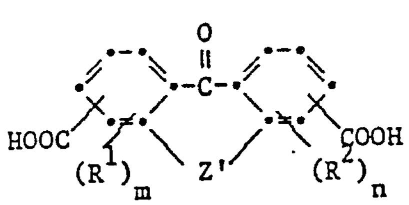

(VII),

worin Z' $-CH_2-$, -S-, -SO- oder $-CR^6R^7-$ bedeutet wobei $R^6$ ein Wasserstoffatom, $C_1C_{10}$-Alkyl, Phenyl, Naphthyl oder Phenyl-$(C_aH_{2a})$ mit a = 1-4 ist und $R^7$ die Bedeutung von $R^6$ mit Ausnahme der Bedeutung eines Wasserstoffatoms hat, $R^1$ und $R^2$ unabhängig voneinander für $C_1$-$C_{10}$-Alkyl, Halogen -CN, $-NO_2$, $C_1$-$C_{12}$-Alkoxy. Phenoxy, Naphthoxy oder Phenyl-$(C_aH_{2a})$ mit a = 1-4 stehen und m und n unabhängig voneinander 0, 2 oder 3 sind, sowie die Anhydride, Ester, Amide und Halogenide dieser Säuren.

**25.** Verwendung der Polykondensate gemäss Anspruch 1 zur Herstellung von Oberflächenbeschichtungen oder von Reliefabbildungen.

## Claims

1. A process for the preparation of a crosslinked polymer, which comprises irradiating radiation-sensitive linear saturated homo- and copolycondensates with high-energy radiation, said polycondensates being selected from the group consisting of polyesters, polyester amides and polyamides which contain at least 10 mol%, based on the polycondensate, of a recurring structural element of formula I

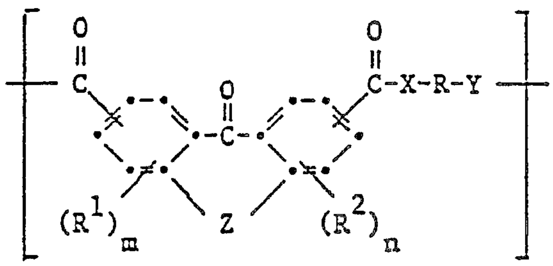

(I)

and, in the case of a copolycondensate, additionally recurring structural elements of formula II

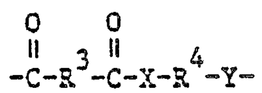

(II)

in which m and n are each independently of the other a number from 0 to 3 , X and Y are each independently of the other -S-, -O-, or $NR^5$, Z is a direct bond, $-CH_2-$, -O-, -S-, -SO-, $-SO_2-$, -CO-, $NR^6$ or $-CR^6R^7-$, where $R^6$ is a hydrogen atom, $C_1$-$C_{10}$alkyl, phenyl, naphthyl or phenyl($C_aH_{2a}$), where a is 1 to 4, and $R^7$ has the same meaning as $R^6$ but is not a hydrogen atom, $R^1$ and $R^2$ are each independently of the other $C_1$-$C_{10}$alkyl, halogen, -CN, $-NO_2$, $C_1$-$C_{12}$alkoxy, phenoxy, naphthoxy or phenyl($C_aH_{2a}$), where a is 1 to 4,
R is an unsubstituted or substituted divalent aliphatic, cycloaliphatic, araliphatic or aromatic radical, and, if X and Y are the $-NR^5-$ group, R and one of the $R^5$ together are alkylene of 5 to 7 carbon atoms to which the second $-NR^5-$ group is attached, or R is methylene, ethylene or propylene, and the two radicals $R^5$ of the $NRC^5-$ groups together are ethylene or propylene or, if one of X or Y is -S- or -O- and the other is $-NR^5-$, R and $R^5$ together are alkylene of 5 to 7 carbon atoms,
$R^4$ has independently the same meaning as R,
$R^3$ is a divalent saturated aliphatic or aromatic radical, and
$R^5$ is a hydrogen atom, alkyl, cycloalkyl, aryl, aralkyl or alkaralkyl.

2. A process for the production of surface coatings or relief images comprising the steps
   i) coating a substrate with a polycondensate according to claim 1,
   ii) exposing the polycondensate layer with high-energy radiation, where the exposure can take place directly or imagewise,
   iii) removing the unexposed portions of the polycondensate layer by developing with a solvent or solvent mixture, and
   iv) if desired, stabilising the image produced by thermal aftertreatment.

3. A radiation-sensitive linear saturated homo- or copolycondensate selected from the group of polyesters, polyester amides and polyamides containing at least 10 mol%, based on the polycondensate, of a recurring structural element of formula I

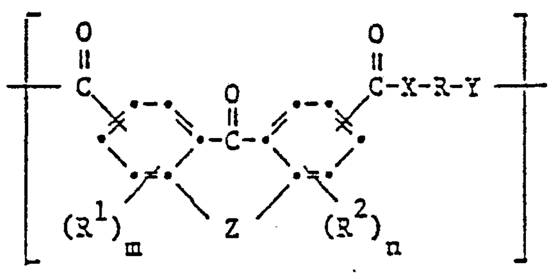

(I)

and, in the case of a copolycondensate, additionally recurring structural elements of formula II

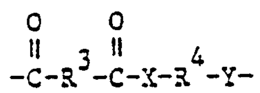

(II)

in which m and n are each independently of the other a number from 0 to 3, X and Y are each independently of the other -S-, -O-, or $-NR^5-$, Z is $-CH_2-$, -O-, -S-, -SO-, $-SO_2-$, -CO-, $NR^6$ or $-cR^6R^7-$, where $R^6$ is a hydrogen atom, $C_1$-$C_{10}$alkyl, phenyl, naphthyl or phenyl($C_aH_{2a}$), where a is 1 to 4, and $R^7$ has the same meaning as $R^6$ but is not a hydrogen atom, $R^1$ and $R^2$ are each independently of the other $C_1$-$c_{10}$alkyl, halogen, -CN, $-NO_2$, $C_1$-$C_{12}$alkoxy, phenoxy, naphthoxy or phenyl($C_aH_{2a}$), where a is 1 to 4,
R is an unsubstituted or substituted divalent aliphatic, cycloaliphatic, araliphatic or aromatic radical, and, if X and Y are the $-NR^5-$ group, R and one of the $R^5$ together are alkylene of 5 to 7 carbon atoms to which the second $-NR^5-$ group is attached, or R is methylene, ethylene or propylene, and the two radicals $R^5$ of the $NR^5-$ groups together are ethylene or propylene or, if one of X or Y is -S- or -O- and the other is $-NR^5-$, R and $R^5$ together are alkylene of 5 to 7 carbon atoms,
$R^4$ has independently the same meaning as R,
$R^3$ is a divalent saturated aliphatic or aromatic radical, and
$R^5$ is a hydrogen atom, alkyl, cycloalkyl, aryl, aralkyl or alkaralkyl.

4. A process according to claim 1 or 2 or a polycondensate according to claim 3, wherein the copolycondensate contains at least 50 mol%, preferably at least 70 mol% and, in particular, at least 90 mol%, of the structural elements of formula I.

5. A process according to claim 1 or 2 or a polycondensate according to claim 3, wherein $R^5$ is alkyl of 1 to 6 carbon atoms, phenyl or benzyl, or particularly a hydrogen atom.

6. A process according to claim 1 or 2 or a polycondensate according to claim 3, wherein the carbonyl groups in the structural elements of formula I are attached in the meta-position and, particularly, in the para-position to the carbonyl group in the ring.

7. A process according to claim 1 or 2 or a polycondensate according to claim 3, wherein R or $R^4$ contains 2 to 30 carbon atoms as an aliphatic radical, 5 to 8 ring carbon atoms as a cycloaliphatic radical, 7 to 30 carbon atoms as an araliphatic radical, and 6 to 30 carbon atoms as an aromatic radical.

8. A process according to claim 1 or 2 or a polycondensate according to claim 3, wherein X and Y in formulae I and II are the $-NR^5-$ group and the aliphatic or araliphatic radical contains 6 to 22 carbon atoms, or X and Y in formulae I and II are -O- and the aliphatic radical contains 2 to 12 carbon atoms.

9. A process according to claim 1 or 2 or a polycondensate according to claim 3, wherein an aliphatic radical R or $R^4$ independently of the other is linear or branched alkylene which can be interrupted by oxygen atoms, NH, $NR^a$ or $^{+}NR^a_2\ G^-$, in which $R^a$ is alkyl of 1 to 12 carbon atoms, cycloalkyl containing 5 or 6 ring carbon atoms, phenyl or benzyl and $G^-$ is the anion of a protic acid, or by cyclohexylene, naphthylene, phenylene or a hydantoin; a cycloaliphatic radical R or $R^4$ is monocyclic or bicyclic cycloalkylene which has 5 to 7 ring carbon atoms and is unsubstituted or substituted by alkyl; an

araliphatic radical R or $R^4$ is aralkylene which is unsubstituted or substituted on the aryl by alkyl, where the alkylene radical can be linear or branched; or an aromatic radical R or $R^4$ is a hydrocarbon radical or a pyridine radical which is unsubstituted or substituted by alkyl, alkoxy, alkoxyalkyl, trimethylene or tetramethylene.

**10.** A process or a polycondensate according to claim 9, wherein an aliphatic radical R or $R^4$ is linear or branched alkylene of 2 to 30 carbon atoms, $-(CH_2)_x-R^8-(CH_2)_y-$, in which $R^8$ is phenylene, naphthylene, cyclopentylene or cyclohexylene and x and y are each independently of the other a number 1, 2 or 3, $-R^9-(OR^{10})_p-O-R^9$, in which $R^9$ is ethylene, 1,2-propylene, 1,3-propylene or 2-methyl-1,3-propylene, $R^{10}$ is ethylene, 1,2-propylene, 1,2-butylene, 1,3-propylene or 1,4-butylene and p is a number from 1 to 100, or

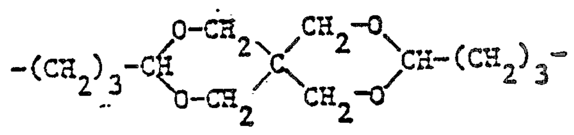

**11.** A process or a polycondensate according to claim 9, wherein a cycloaliphatic radical R or $R^4$ is a radical of formula

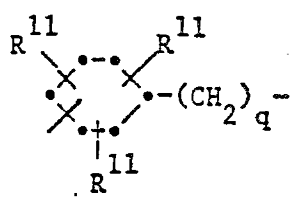

or

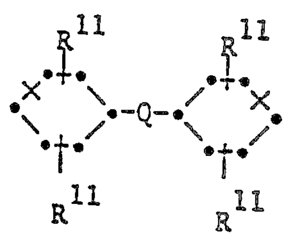

in which q is 0 or 1, each $R^{11}$ is independently hydrogen or alkyl of 1 to 6 carbon atoms and Q is a direct bond, O, S, $SO_2$, alkylene of 1 to 3 carbon atoms or alkylidene of 2 to 6 carbon atoms.

**12.** A process or a polycondensate according to claim 9, wherein an aromatic radical R or $R^4$ is substituted by alkyl, alkoxy or alkoxyalkyl, each of 1 to 6 carbon atoms, or two adjacent carbon atoms of the aromatic radical are substituted by trimethylene or tetramethylene.

**13.** A process or a polycondensate according to claim 12, wherein X and Y in formulae I and II are the $-NR^5-$ group and one or two of the substituents are attached in the ortho-position to the $-NR^5-$ group.

**14.** A process or a polycondensate according to claim 9, wherein the araliphatic radical has the formula

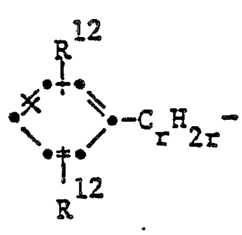

in which each $R^{12}$ independently is a hydrogen atom or alkyl of 1 to 6 carbon atoms and each r is an integer from 1 to 16.

**15.** A process or a polycondensate according to claim 14, wherein the free bond is in the para-position to the $C_rH_{2r}$ group and one $R^{12}$ or each $R^{12}$ as alkyl is in the ortho-position to the free bond.

**16.** A process or a polycondensate according to claim 9, wherein the aromatic radical has the formula

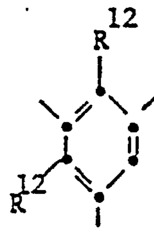 , 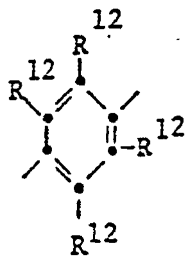 , 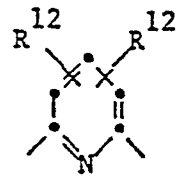 ,

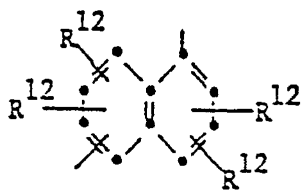 , 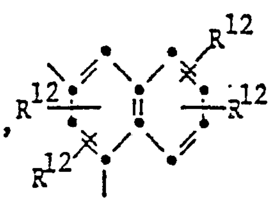 , 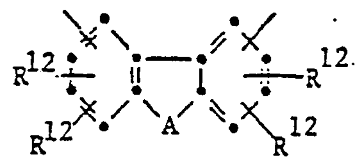 ,

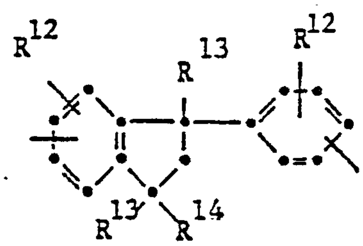 or 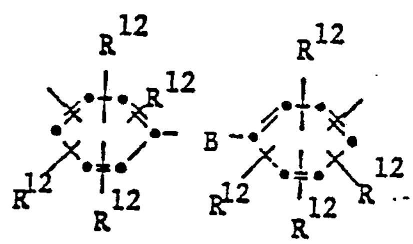

in which each $R^{12}$ is a hydrogen atom and, in the case of monosubstitution, one substituent $R^{12}$ is alkyl of 1 to 6 carbon atoms and the other substituents $R^{12}$ are hydrogen, and in the case of di-, tri- or tetra-substitution, two substituents $R^{12}$ are alkyl of 1 to 6 carbon atoms and the other substituents $R^{12}$ are hydrogen atoms or alkyl of 1 to 6 carbon atoms, or in the case of di-, tri- or tetra-substitution, two vicinal substituents $R^{12}$ in the phenyl ring are trimethylene or tetramethylene and the other substituents $R^{12}$ are hydrogen atoms or alkyl of 1 to 6 carbon atoms, A is O, S, NH, CO or $CH_2$, $R^{13}$ is a hydrogen atom or alkyl of 1 to 5 carbon atoms, $R^{14}$ is alkyl of 1 to 5 carbon atoms and B is a direct bond, O, S, SO, $SO_2$, CO,

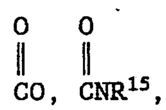

$NR^{15}$, CONH, NH, $R^{15}SiR^{16}$, $R^{15}OSiOR^{16}$, alkylene of 1 to 6 carbon atoms, alkenylene of alkylidene of 2 to 6 carbon atoms, phenylene or phenyldioxyl, in which $R^{15}$ and $R^{16}$ are each independently of the other alkyl of 1 to 6 carbon atoms or phenyl.

**17.** A process or a polycondensate according to claim 16, wherein the aromatic radical has the formula

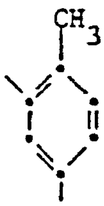 , 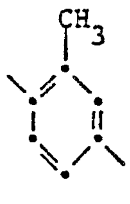 , 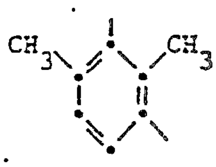 , 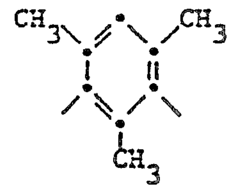 , 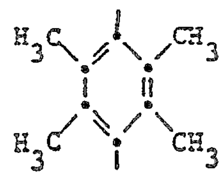 ,

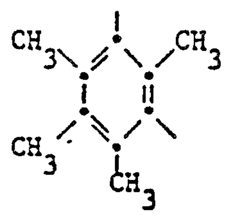 or 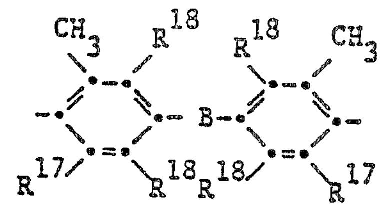

in which B is a direct bond, O and, particularly, $CH_2$, and $R^{17}$ and $R^{18}$ are each independently of the other a hydrogen atom or methyl or ethyl.

**18.** A process according to claim 1 or 2 or a polycondensate according to claim 3, wherein X and Y in formulae I and II are the $-NR^5-$ group and R and $R^4$ are a radical as defined in claim 15, in which $R^{17}$ is methyl or ethyl and $R^{18}$ is hydrogen, methyl or ethyl; or X and Y in formulae I and II are branched alkylene of 6 to 20 carbon atoms which is preferably branched in the $\alpha$-position to the $-NR^5-$ group.

**19.** A process according to claim 1 or 2 or a polycondensate according to claim 3, wherein $R^3$ in formula II is linear or branched alkylene of 2 to 12 carbon atoms, cycloalkylene containing 5 to 7 ring carbon atoms or an aromatic hydrocarbon radical of 6 to 18 carbon atoms.

**20.** A process or a polycondensate according to claim 19, wherein $R^3$ in formula II is a structural element of formula III

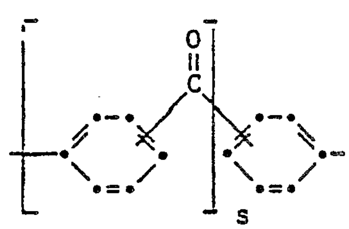 (III)

in which s is 1 to 6.

**21.** A process according to claim 1 or 2 or a polycondensate according to claim 3, wherein Z in formula I is -CO-, $-SO_2-$ or -O-.

**22.** A process according to claim 1 or 2 or a polycondensate according to claim 3, which contains the structural element

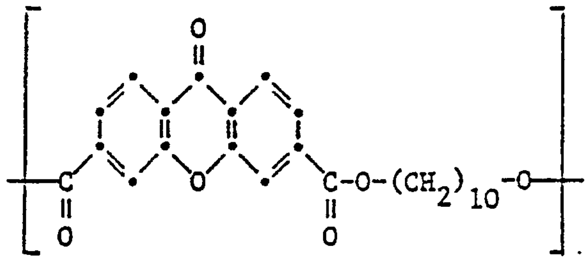

**23.** A process for the preparation of a polycondensate according to claim 3, which comprises polycondensing a dicarboxylic acid of formula IV

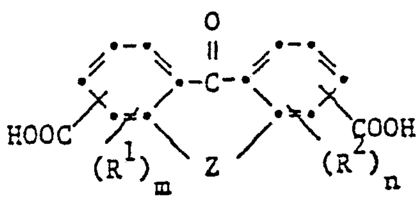

(IV)

in which Z, $R^1$, $R^2$, m and n are as defined in claim 3, or a mixture of these acids, in an amount of at least 10 mol%, based on the polycondensate, optionally together with a dicarboxylic acid of formula V

$HOOC-R^3-COOH$ (V)

or a polyester or polyamide forming derivative thereof with a diol, dimercaptan, a diamine, an amino alcohol, an amino mercaptan, a hydroxymercaptan of formula VI or with a mixture of these monomers

HX - R - YH (VI)

in which X and Y are either -O-, -S- or $-NHR^5-$ or X is -O- or -S- and Y is $-NHR^5-$, and R, $R^3$ and $R^5$ have the given meanings.

**24.** A dicarboxylic acid of formula VII

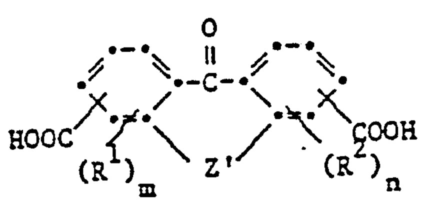

(VII)

in which Z' is $-CH_2-$, -S-, -SO- or $-CR^6R^7-$, where $R^6$ is a hydrogen atom, $C_1$-$C_{10}$alkyl, phenyl, naphthyl or phenyl($C_aH_{2a}$), where a is 1 to 4 and $R^7$ has the meaning of $R^6$ but is not a hydrogen atom, $R^1$ and $R^2$ are each independently of the other $C_1$-$C_{10}$alkyl, halogen, $-CN_2$, $-NO_2$, $C_1$-$C_{12}$alkoxy, phenoxy, naphthoxy or phenyl($C_aH_{2a}$), where a is 1 to 4 and m and n are each independently of the other 0,1,2 or 3, or also an anhydride, ester, amide or halide of this acid.

**25.** Use of a polycondensate according to claim 1 for the production of surface coatings or relief images.

**Revendications**

**1.** Procédé de préparation de polymères réticulés, procédé caractérisé en ce que l'on irradie par un

rayonnement à forte énergie des homo- ou copolycondensats linéaires saturés, sensibles aux rayonnements, pris dans le groupe formé de polyesters, polyesters-amides et polyamides, comprenant au moins 10 mol-% d'un motif récurrent de formule I ci-dessous :

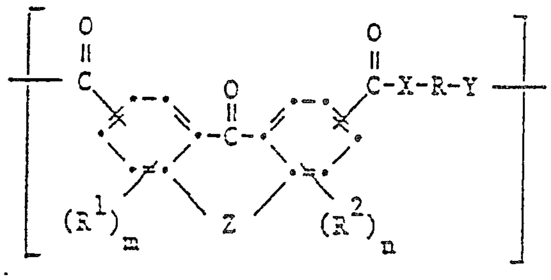

(I)

et dans le cas de copolycondensats également des motifs de formule II :

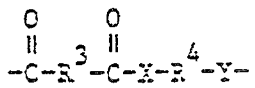

(II),

formules dans lesquelles m et n sont chacun, indépendamment l'un de l'autre, un nombre de 0 à 3,

X et Y représentent chacun, indépendamment l'un de l'autre, -S-, -O- ou $-NR^5-$, Z désigne une liaison directe ou bien $-CH_2-$, -O-, -S-, -SO-, $-SO_2-$, -CO-, $-NR^6-$ ou $-CR^6R^7-$, $R^6$ étant un atome d'hydrogène, un alkyle en $C_1$-$C_{10}$, un phényle, un naphtyle ou un groupe phényle-($C_aH_{2a}$), a étant un nombre de 1 à 4, et $R^7$ ayant la même signification que $R^6$ à l'exception de l'hydrogène, $R^1$ et $R^2$ sont chacun, indépendamment l'un de l'autre, un alkyle en $C_1$-$C_{10}$, un halogène, un groupe -CN- ou $-NO_2-$, un alcoxy en $C_1$-$C_{12}$, un phénoxy, un naphtoxy ou un phényle($C_aH_{2a}$), a étant un nombre de 1 à 4,

R désigne un radical divalent aliphtique, cycloaliphatique, araliphatique ou aromatique, avec ou sans substituants, et si X et Y sont le groupe $-NR^5-$, R et l'un des $R^5$ forment ensemble un alkylène en $C_5$ à $C_7$ auquel est lié le second groupe $-NR^5-$, ou bien R est un groupe méthylène, éthylène ou propylène et les deux $R^5$ des groupes $-NR^5-$forment ensemble un groupe éthylène ou propylène, ou encore si parmi X et Y l'un est un atome de soufre ou d'oxygène et l'autre un groupe $-NR^5-$, R et $R^5$ forment ensemble un alkylène en $C_{5-7}$,

$R^4$ a, indépendamment, la même signification que R,

$R^3$ désigne un radical aliphatique ou aromatique saturé divalent, et

$R^5$ un atome d'hydrogène, un alkyle, un cycloalkyle, un aryle, un aralkyle ou un alcaralkyle.

**2.** Procédé de formation de revêtements de surface ou d'images ou représentations en relief, qui comprend les oéprations suivantes :

1) revêtement d'un substrat d'un polycondensat selon la revendication 1,

2) irradiation de la couche du polycondensat par un rayonnement à haute énergie, irradiation qui peut être totale, ou bien seulement partielle en vue de former une image,

3) élimination des parties non-irradiées de la couche du polycondensat par développement avec un solvant ou un mélange de plusieurs solvants et

4) éventuellement stabilisation de l'image produite par un traitement à la chaleur.

**3.** Homo- et copolycondensats linéaires saturés, sensibles aux rayonnements, du groupe des polyesters, polyesters-amides et polyamides, comprenant au moins 10 mol-% d'un motif récurrent de formule I ci-dessous :

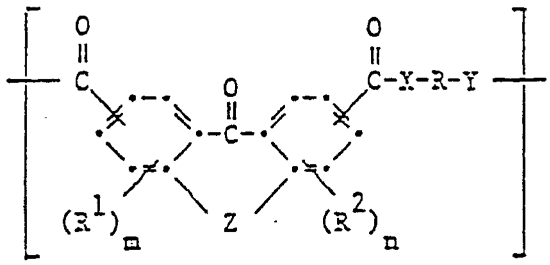

(I)

et dans le cas de copolycondensats également des motifs de formule II :

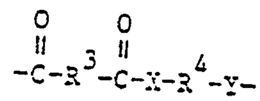

(II),

formules dans lesquelles m et n sont chacun, indépendamment l'un de l'autre, un nombre de 0 à 3,

X et Y représentent chacun, indépendamment l'un de l'autre, -S-, -O- ou $-NR^5-$, Z désigne une liaison directe ou bien $-CH_2-$, -O-, -S-, -SO-, $-SO_2-$, -CO-, $-NR^6-$ ou $-CR^6R^7-$, $R^6$ étant un atome d'hydrogène, un alkyle en $C_1$-$C_{10}$, un phényle, un naphtyle ou un groupe phényle-$(C_aH_{2a})$, a étant un nombre de 1 à 4, et $R^7$ ayant la même signification que $R^6$ à l'exception de l'hydrogène, $R^1$ et $R^2$ sont chacun, indépendamment l'un de l'autre, un alkyle en $C_1$-$C_{10}$, un halogène, un groupe -CN- ou $-NO_2-$, un alcoxy en $C_{1\text{-}10}$, un phénoxy, un naphtoxy ou un phényle$(C_aH_{2a})$, a étant un nombre de 1 à 4,

R désigne un radical divalent aliphtique, cycloaliphatique, araliphatique ou aromatique, avec ou sans substituants, et si X et Y sont le groupe $-NR^5-$, R et l'un des $R^5$ forment ensemble un alkylène en $C_5$ à $C_7$ auquel est lié le second groupe $-NR^5-$, ou bien R est un groupe méthylène, éthylène ou propylène et les deux $R^5$ des groupes $-NR^5$-forment ensemble un groupe éthylène ou propylène, ou encore si parmi X et Y l'un est un atome de soufre ou d'oxygène et l'autre un groupe $-NR^5-$, R et $R^5$ forment ensemble un alkylène en $C_{5\text{-}7}$,

$R^4$ a, indépendamment, la même signification que R,

$R^3$ désigne un radical aliphatique ou aromatique saturé divalent, et

$R^5$ un atome d'hydrogène, un alkyle, un cycloalkyle, un aryle, un aralkyle ou un alcaralkyle.

4. Procédé selon la revendication 1 ou 2 ou polycondensats selon la revendication 3, caractérisés en ce que les motifs de formule I forment au moins 50 mol-% du copolycondensat, de préférence au moins 70 mol-% et plus spécialement au moins 90 mol-%.

5. Procédé selon la revendication 1 ou 2 ou polycondensats selon la revendication 3, caractérisés en ce que $R^5$ est un alkyle en $C_{1\text{-}6}$, un phényle ou un benzyle, mais plus particulièrement un atome d'hydrogène.

6. Procédé selon la revendication 1 ou 2 ou polycondensats selon la revendication 3, caractérisés en ce que les groupes carbonyles des motifs de formule I sont en position méta et notamment en position para par rapport au groupe carbonyle du cycle.

7. Procédé selon la revendication 1 ou 2 ou polycondensats selon la revendication 3, caractérisés en ce que R et $R^4$ ont chacun de 2 à 30 atomes de carbone en tant que radicaux aliphatiques, de 5 à 8 atomes de carbone dans le cycle en tant que radicaux cycloaliphatiques, de 7 à 30 atomes de carbone en tant que radicaux araliphatiques et de 6 à 30 en tant que radicaux aromatiques.

8. Procédé selon la revendication 1 ou 2 ou polycondensats selon la revendication 3, caractérisés en ce que X et Y dans les formules I et II sont le groupe $-NR^5-$ et le radical aliphatique ou araliphatique a de 6 à 22 atomes de carbone, ou bien X et Y représentent l'oxygène et le radical aliphatique a de 2 à 12

atomes de carbone.

9. Procédé selon la revendication 1 ou 2 ou polycondensats selon la revendication 3, caractérisés en ce que R et $R^4$ sont indépendamment l'un de l'autre, comme radicaux aliphatiques, des alkylènes linéaires ou ramifiés pouvant être interrompus par des atomes d'oxygène, les groupes NH, $NR^a$ ou $^+NR_2{}^aG^-$, Ra étant un alkyle en $C_{1-12}$ ou un cycloalkyle avec 5 ou 6 atomes de carbone dans le cycle, un phènyle ou un benzyle, et $G^-$ l'anion d'un acide protonique, ou encore par les groupes cyclohexylène, naphtylène, phénylène ou d'hydantoïne ; comme radicaux cycloaliphatiques ce sont des cycloalkylènes monocycliques ou bicycliques ayant de 5 à 7 atomes de carbone dans les cycles, sans substituants ou portant un alkyle ; comme radicaux araliphatiques ce sont des aralkylènes sans substituants ou avec un aryle ou un alkyle, l'alkylène pouvant être linéaire ou ramifié ; et comme radicaux aromatiques il s'agit de radicaux hydrocarbonés ou pyridiniques sans substituants ou avec comme substituants un groupe alkyle, alcoxy, alcoxyalkyle, triméthylène ou tétraméthylène.

10. Procédé ou polycondensats selon la revendication 9, caractérisés en ce que R et $R^4$, comme radicaux aliphatiques, sont des alkylènes linéaires ou ramifiés en $C_{2-30}$, des radicaux $-(CH_2)_x-R^8-(CH_2)_y-$, $R^8$ étant un phénylène, un naphtylène, un cyclopentylène ou un cyclohexylène et x et y, indépendamment l'un de l'autre, le nombre 1, 2 ou 3, des radicaux $-R^9-(OR^{10})_p-O-R^9-$, $R^9$ étant le groupe éthylène, 1,2-propylène, 1,3-propylène ou 2-méthyl-1,3-propylène et $R^{10}$ le groupe éthylène, 1,2-propylène, 1,2-butylène, 1,3-propylène ou 1,4-butylène, et p un nombre de 1 à 100, ou encore des radicaux

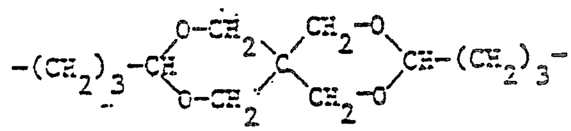

11. Procédé ou polycondensats selon la revendication 9, caractérisé en ce que R et $R^4$, en tant que radicaux cycloaliphatiques, sont des radicaux de formule :

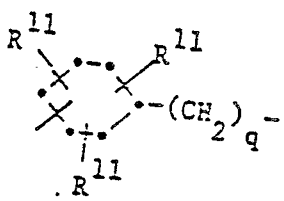

ou

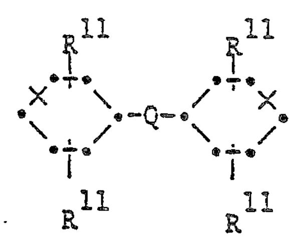

formules dans lesquelles q est le nombre 0 ou 1, les $R^{11}$, sont, indépendamment les uns des autres, l'hydrogène ou un alkyle en $C_{1-6}$ et Q représente une liaison directe ou bien O, S, $SO_2$, un alkylène en $C_{1-3}$ ou un alkylidène en $C_{2-6}$.

12. Procédé ou polycondensats selon la revendication 9, caractérisés en ce que R et $R^4$, en tant que radicaux aromatiques, sont substitués par des alkyles, alcoxy ou alcoxyalkyles en $C_{1-6}$ ou deux atomes de carbone voisins du radical aromatique sont liés à un groupe triméthylène ou tétraméthylène.

13. Procédé ou polycondensats selon la revendication 12, caractérisés en ce que X et Y dans les formules I et II sont le groupe $-NR^5-$ et un ou deux substituants sont liés en position ortho par rapport au groupe $-NR^5-$.

14. Procédé ou polycondensats selon la revendication 9, caractérisés en ce que le radical araliphatique est un radical de formule :

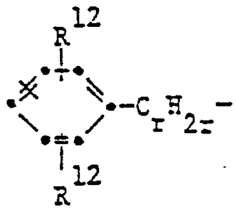

les $R^{12}$ étant indépendamment l'un de l'autre un atome d'hydrogène ou un alkyle en $C_{1-6}$ et r un entier de 1 à 16.

**15.** Procédé ou polycondensats selon la revendication 14, caractérisés en ce que la liaison libre est à la position para par rapport au groupe $C_rH_{2r}$ et l'un des $R^{12}$ ou les deux, comme alkyles, sont en position ortho par rapport à la liaison libre.

**16.** Procédé ou polycondensats selon la revendication 9, caractérisés en ce que le radical aromatique est un radical de formule :

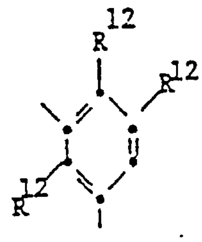 ,

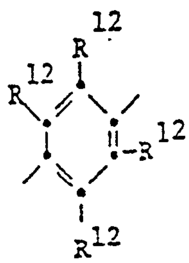 ,

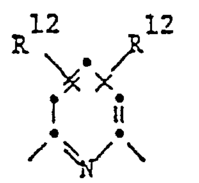 ,

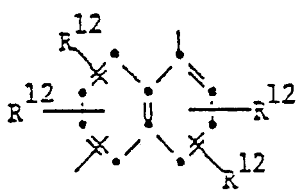

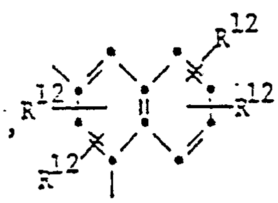 ,

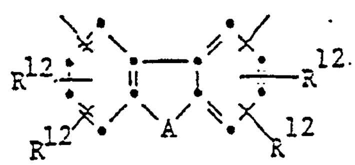 ,

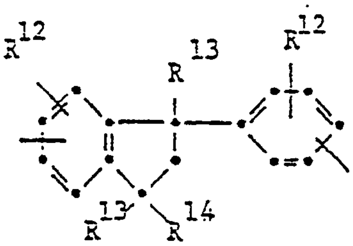

ou

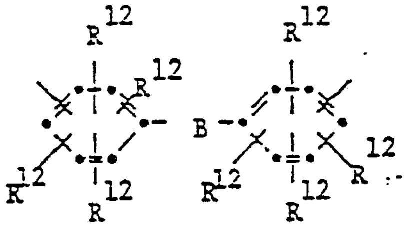

dans lesquels $R^{12}$ est un atome d'hydrogène ou dans le cas d'une monosubstitution l'un est un alkyle en $C_{1-6}$ et les autres $R^{12}$ sont l'hydrogène, et dans le cas d'une di-, tri-ou tétra-substitution, deux $R^{12}$ sont des alkyles en $C_{1-6}$ et les autres l'hydrogène ou des alkyles en $C_{1-6}$, ou également dans le cas d'une di-, tri- ou tétra-substitution deux $R^{12}$ voisins sur le cycle phénylique forment un groupe

timéthylène ou tétraméthylène et les autres sont l'hydrogène ou des alkyles en $C_{1-6}$, A désigne O, S, NH, CO ou $CH_2$, $R^{13}$ un atome d'hydrogène ou un alkyle en $C_{1-5}$ et $R^{14}$ un alkyle en $C_{1-5}$, et B une liaison directe ou bien O, S, SO, $SO_2$, CO,

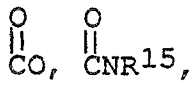

$NR^{15}$, CONH, NH, $R^{15}SiR^{16}$, $R^{15}OSiOR^{16}$, un alkylène en $C_{1-6}$, un alcénylène ou un alkylidène en $C_{2-6}$, un phénylène ou un phényldioxy, $R^{15}$ et $R^{16}$ étant chacun, indépendamment l'un de l'autre, un alkyle en $C_{1-6}$ ou un phényle.

**17.** Procédé ou polycondensats selon la revendication 16, caractérisés en ce que le radical aromatique est un radical :

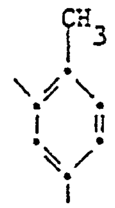, 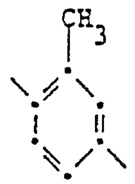, 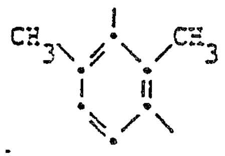, 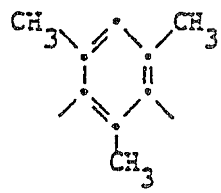, 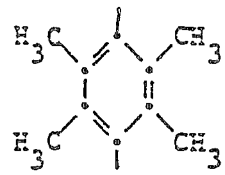,

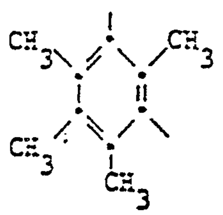 ou 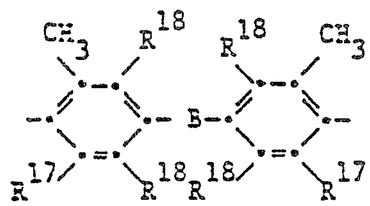

B désignant une liaison directe, un atome d'oxygène ou en particulier le groupe $CH_2$, et $R^{17}$ et $R^{18}$ étant chacun, indépendamment l'un de l'autre, un atome d'hydrogène ou le groupe méthyle ou éthyle.

**18.** Procédé selon la revendication 1 ou 2 ou polycondensats selon la revendication 3, caractérisés en ce que X et Y dans les formules I et II sont le groupe $-NR^5-$ et R et $R^4$ des radicaux selon la revendication 15, $R^{17}$ étant le groupe méthyle ou éthyle et $R^{18}$ l'hydrogène ou le groupe méthyle ou éthyle ; ou bien X et Y sont des alkylènes ramifiés en $C_{6-20}$, de préférence ramifiés à la position $\alpha$ par rapport au groupe $-NR^5-$.

**19.** Procédé selon la revendication 1 ou 2 ou polycondensats selon la revendication 3, caractérisés en ce que $R^3$ dans la formule II est un alkylène linéaire ou ramifié en $C_{2-12}$, un cycloalkylène avec de 5 à 7 atomes de carbone dans le cycle ou un radical hydrocarboné aromatique en $C_{6-18}$.

**20.** Procédé ou polycondensats selon la revendication 19, caractérisés en ce que $R^3$ dans la formule II est un motif de formule III :

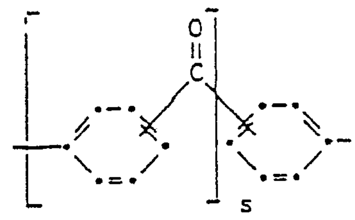 (III),

s étant un nombre de 1 à 6.

**21.** Prooédé selon la revendication 1 ou 2 ou polycondensats selon la revendication 3, caractérisés en ce que Z dans la formule I désigne -CO-, $SO_2$- ou -O-.

**22.** Procédé selon la revendication 1 ou 2 ou polycondensats selon la revendication 3, caractérisés en ce que les polycondensats comportent le motif :

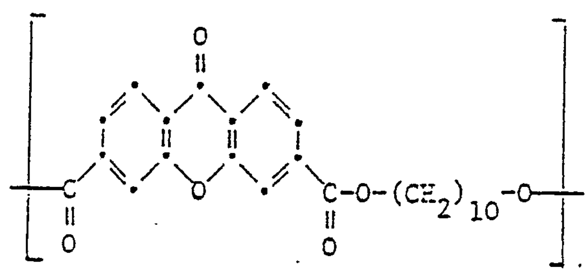

**23.** Procédé de préparation de polycondensats selon la revendication 3, caractérisé en ce que l'on soumet à une polycondensation des acides dicarboxyliques de formule IV :

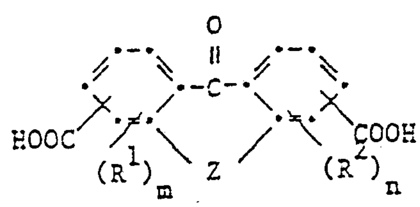 (IV),

les divers symboles ayant les significations indiquées à la revendication 3, ou des mélanges de ces acides, dans une proportion d'au moins 10 mol-% par rapport au polycondensat, éventuellement avec un acide dicarboxylique de formule V :

HOOC-$R^3$-COOH (V)

ou leurs dérivés pouvant former des polyesters ou des polyamides, avec un diol, un dimercaptan, une diamine, un aminoalcool, un aminomercaptan ou un hydroxymercaptan de formule VI ou un mélange de plusieurs de ces monomères

HX - R - YH (VI),

X et Y désignant chacun -O-, -S- ou -$NHR^5$- ou bien X désignant -O- ou -S- et Y un groupe -$NHR^5$-, et R, $R^3$ et $R^5$ ayant les significations indiquées.

**24.** Les acides dicarboxyliques de formule VII

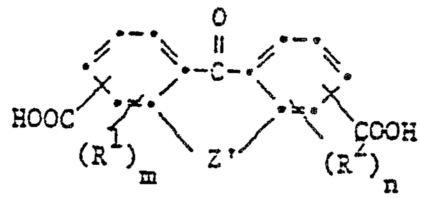

(VII),

dans laquelle Z' représente un groupe $-CH_2-$, -S-, -SO- ou $-CR^6R^7$, $R^6$ étant un atome d'hydrogène, un alkyle en $C_{1-10}$, un phényle, un naphtyle ou un phényle-$(C_aH_{2a})$, a étant un nombre de 1 à 4, et $R^7$ ayant la même signification que $R^6$ à à l'exception de l'hydrogène, $R^1$ et $R^2$ sont chacun, indépendamment l'un de l'autre, un alkyle en $C_{1-10}$, un halogène ou un groupe -CN- ou $-NO_2-$, alcoxy en $C_{1-12}$, phénoxy, naphtoxy ou un phényle-$(C_aH_{2a})$, a étant un nombre de 1 à 4, et m et n sont, indépendamment l'un de l'autre, le nombre 0, 1, 2 ou 3, ainsi que les anhydrides, esters, amides et halogénures de ces acides.

**25.** L'emploi des produits de polycondensation selon la revendication 1 pour former des revêtements de surface ou des images, figures et représentations en relief.